# EUROPEAN PATENT APPLICATION

(11) **EP 4 712 718 A1**
(43) Date of publication of application: **18.03.2026**
(21) Application number: 25192544.2
(22) Date of filing: 29.07.2025
(51) Int. Cl.: H10B 12/00, H10D 1/68

(54) **SEMICONDUCTOR MEMORY DEVICE**

(30) Priority: 13.09.2024 KR 20240126175
(71) Applicant: Samsung Electronics Co., Ltd., Suwon-si, Gyeonggi-do 16677 (KR)
(72) Inventor: LIM, Hanjin, 16677 Suwon-si (KR)
(74) Representative: Marks & Clerk LLP

(57) **Abstract**

A semiconductor memory device includes an active region spaced apart from a substrate in a vertical direction and extending in a first direction, the active region including a buried contact, a channel region, and a direct contact, a word line surrounding the channel region and extending in a second direction that crosses the first direction, a capacitor including a first electrode including an electrode support portion and a main electrode portion, the electrode support portion being connected to the buried contact and having a first width in the vertical direction, the main electrode portion being integrally connected to the electrode support portion, and the main electrode portion having a second width in the vertical direction, wherein the second width is greater than the first width, and an insulating liner surrounding the buried contact and the electrode support portion of the first electrode.

## Description

### BACKGROUND

The present disclosure relates to a semiconductor memory device, and more particularly, to a semiconductor memory device including a plurality of memory cells arranged three-dimensionally.

Due to the development of electronics technology, the downscaling of semiconductor devices has rapidly progressed. Thus, the miniaturization of memory cells is required, and related memory cells have limitations in maintaining high integration density and reliability. Accordingly, there is a need for a semiconductor memory device having a structure that facilitates miniaturization and high integration of memory cells.

### SUMMARY

One or more embodiments provide a semiconductor memory device having a structure capable of eliminating the likelihood of defects, which may occur due to undesired deformation of an electrode of a capacitor during manufacturing, and maximizing the capacitance of the capacitor by sufficiently increasing a length of the electrode of the capacitor, even when an area occupied by a plurality of memory cells arranged three-dimensionally and a distance between nodes of capacitors are reduced due to the miniaturization and high integration of the plurality of memory cells.

According to an aspect of an embodiment, a semiconductor memory device includes: an active region spaced apart from a substrate in a vertical direction and extending in a first lateral direction, the active region including a buried contact, a channel region, and a direct contact, which are sequentially provided in the first lateral direction, wherein the first lateral direction is parallel to a main surface of the substrate; a word line surrounding the channel region of the active region and extending in a second lateral direction, wherein the second lateral direction is parallel to the main surface of the substrate and crosses the first lateral direction; a capacitor including a first electrode including an electrode support portion and a main electrode portion, the electrode support portion being connected to the buried contact of the active region and having a first width in the vertical direction, the main electrode portion being integrally connected to the electrode support portion and spaced apart from the buried contact in the first lateral direction with the electrode support portion therebetween, and the main electrode portion having a second width in the vertical direction that is greater than the first width; and an insulating liner surrounding the buried contact and the electrode support portion of the first electrode.

According to another aspect of an embodiment, a semiconductor memory device includes: a memory cell block having a three-dimensional (3D) structure, the memory cell block including a plurality of memory cells repeatedly provided on a substrate in a first lateral direction, a second lateral direction, and a vertical direction, wherein the first lateral direction and the second lateral direction cross each other, and the vertical direction is perpendicular to a main surface of the substrate. The memory cell block includes: a plurality of active regions arranged in a line extending in the vertical direction on the substrate; a plurality of word lines, each of the plurality of word lines surrounding a selected one of the plurality of active regions and extending in the second lateral direction, the plurality of word lines overlapping each other in the vertical direction; a bit line extending in the vertical direction on the substrate, the bit line being connected to one side of each of the plurality of active regions; a plurality of capacitors, each of the plurality of capacitors including a first electrode connected to another side of a selected one of the plurality of active regions, the first electrode including an electrode support portion and a main electrode portion, the electrode support portion having a first width in the vertical direction, the main electrode portion being integrally connected to the electrode support portion and spaced apart from the selected active region in the first lateral direction with the electrode support portion therebetween, and the main electrode portion having a second width in the vertical direction that is greater than the first width; and a plurality of insulating liners, each of the plurality of insulating liners surrounding a selected one of the plurality of active regions and the electrode support portion of the first electrode connected to the selected active region.

According to another aspect of an embodiment, a semiconductor memory device includes: an active region spaced apart from a substrate in a vertical direction and extending in a first lateral direction, the active region including a channel region, a buried contact and a direct contact, and the buried contact and the direct contact being spaced apart from each other in the first lateral direction with the channel region therebetween, wherein the first lateral direction is parallel to a main surface of the substrate; a word line surrounding the channel region of the active region and extending in a second lateral direction, wherein the second lateral direction is parallel to the main surface of the substrate and crosses the first lateral direction; a gate dielectric film between the channel region of the active region and the word line; a bit line connected to the direct contact of the active region; a capacitor including a first electrode connected to the buried contact of the active region, the first electrode including an electrode support portion and a main electrode portion, the electrode support portion having a first width in the vertical direction, the main electrode portion being integrally connected to the electrode support portion and spaced apart from the buried contact in the first lateral direction with the electrode support portion therebetween, and the main electrode portion having a second width in the vertical direction, wherein the second width is greater than the first width; a metal silicide film between the first electrode of the capacitor and the buried contact of the active region; and an insulating liner surrounding the buried contact, the metal silicide film, and the electrode support portion of the first electrode.

At least some of the above and other features of the invention are set out in the claims.

### BRIEF DESCRIPTION OF DRAWINGS

The above and other aspects and features will be more apparent from the following description of embodiments, taken in conjunction with the accompanying drawings, in which:
FIG. 1 is a block diagram of a semiconductor memory device according to embodiments;
FIG. 2 is a plan view of a semiconductor memory device according to embodiments;
FIG. 3 is a cross-sectional view taken along line X1 - X1' of FIG. 2 according to embodiments;
FIG. 4 is an enlarged cross-sectional view of a partial region "EX1" of FIG. 3 according to embodiments;
FIG. 5 is a cross-sectional view taken along line Y1 - Y1' of FIG. 2 according to embodiments;
FIG. 6 is an enlarged cross-sectional view of some components in a cross-section taken along line Y2 - Y2' of FIG. 2 according to embodiments;
FIG. 7 is a cross-sectional view of a semiconductor memory device according to embodiments;
FIG. 8 is an enlarged cross-sectional view of a partial region "EX2" of FIG. 7 according to embodiments;
FIG. 9 is an enlarged cross-sectional of some components in a cross-section taken along line Y2 - Y2' of FIG. 8 according to embodiments;
FIG. 10 is a cross-sectional view of a semiconductor memory device according to embodiments;

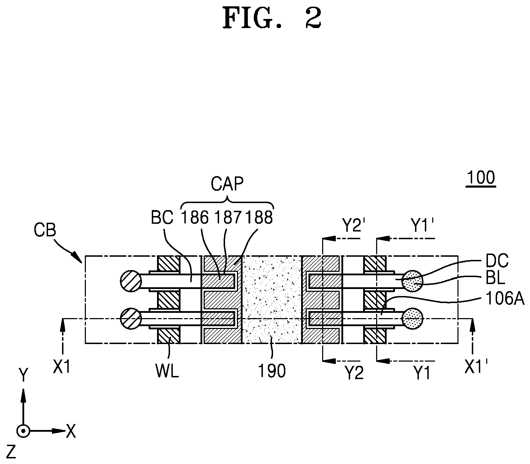

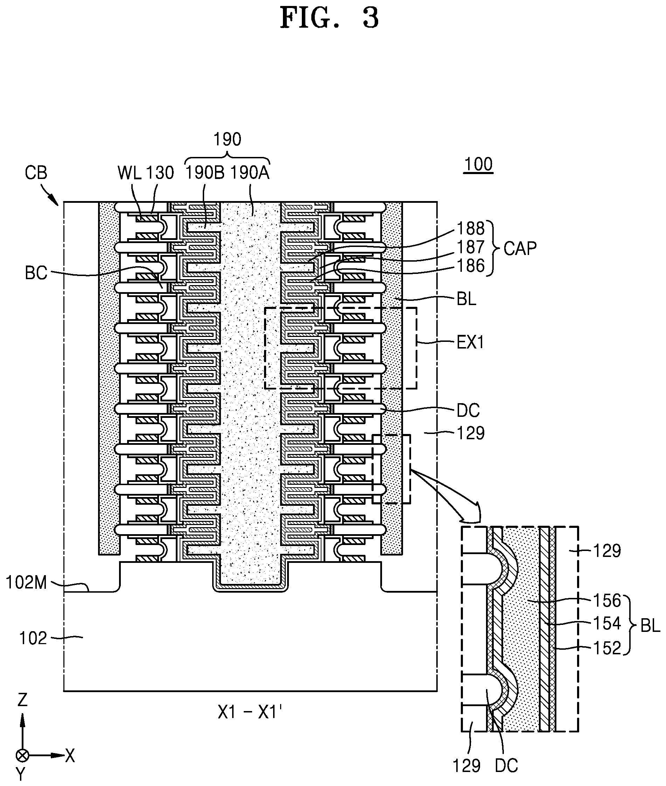

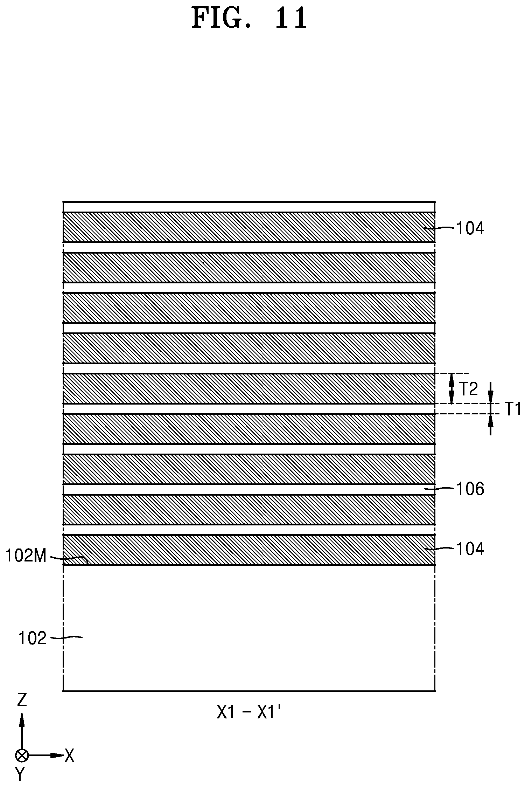

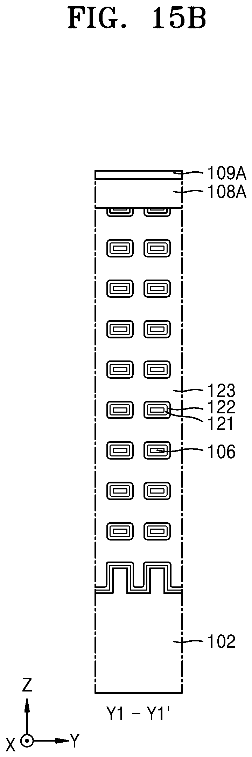

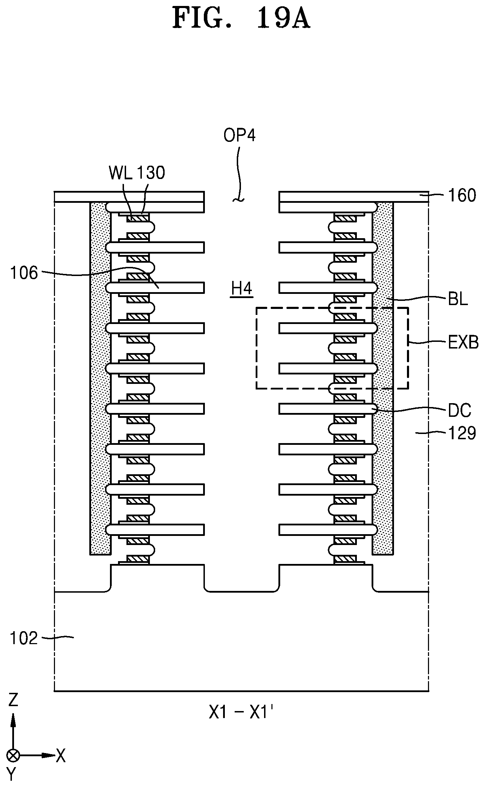

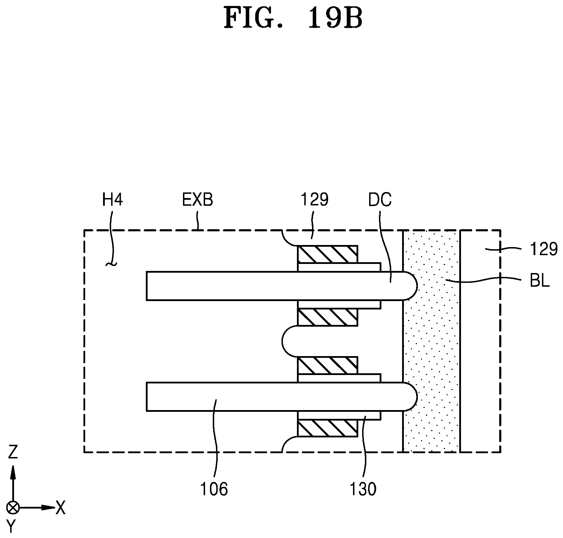

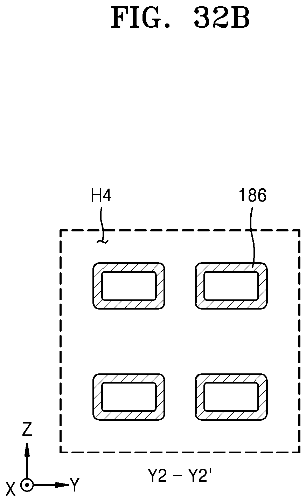

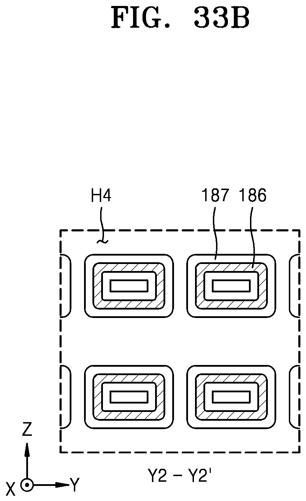

FIGS. 11 to 14, 15A, 15B, 16A, 16B, 17A, 17B, 18, 19A, 19B, 20 to 31, 32A, 32B, 33A and 33B are diagrams of a method of manufacturing a semiconductor memory device, according to embodiments, wherein FIGS. 11, 12, 13, 14, 15A, 16A, 17A, 18, and 19A are each a cross-sectional view of a partial region corresponding to a cross-section taken along line X1 - X1' of FIG. 2, according to a process sequence, FIGS. 15B, 16B, and 17B are each a cross-sectional view of a partial region corresponding to a cross-section taken along line Y1 - Y1' of FIG. 2, FIG. 19B is an enlarged cross-sectional view of a partial region "EXB" of FIG. 19A, FIGS. 20, 21, 22, 23, 24, 25, 26, 27, 28, 29, 30, 31, 32A, and 33A are each an enlarged cross-sectional view of a region corresponding to the partial region "EX1" of FIG. 3, according to the process sequence, and FIGS. 32B and 33B are each a cross-sectional view of a partial region corresponding to a cross-section taken along line Y2-Y2' of FIG. 2, according to the process sequence; and
FIGS. 34, 35A, 35B, 36A and 36B are diagrams of a method of manufacturing a semiconductor memory device, according to embodiments, wherein FIGS. 34, 35A, and 36A are each an enlarged cross-sectional view of a region corresponding to the partial region "EX2" of FIG. 7, according to a process sequence, and FIGS. 35B and 36B are each a cross-sectional view of a partial region corresponding to a cross-section taken along line Y2 - Y2' of FIG. 2, according to the process sequence.

### DETAILED DESCRIPTION

Hereinafter, embodiments will be described in detail with reference to the accompanying drawings. Embodiments described herein are example embodiments, and thus, the present disclosure is not limited thereto, and may be realized in various other forms. Each embodiment provided in the following description is not excluded from being associated with one or more features of another example or another embodiment also provided herein or not provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. It will be also understood that, even if a certain step or operation of manufacturing an apparatus or structure is described later than another step or operation, the step or operation may be performed later than the other step or operation unless the other step or operation is described as being performed after the step or operation. The same reference numerals are used to denote the same elements in the drawings, and repeated descriptions thereof will be omitted.

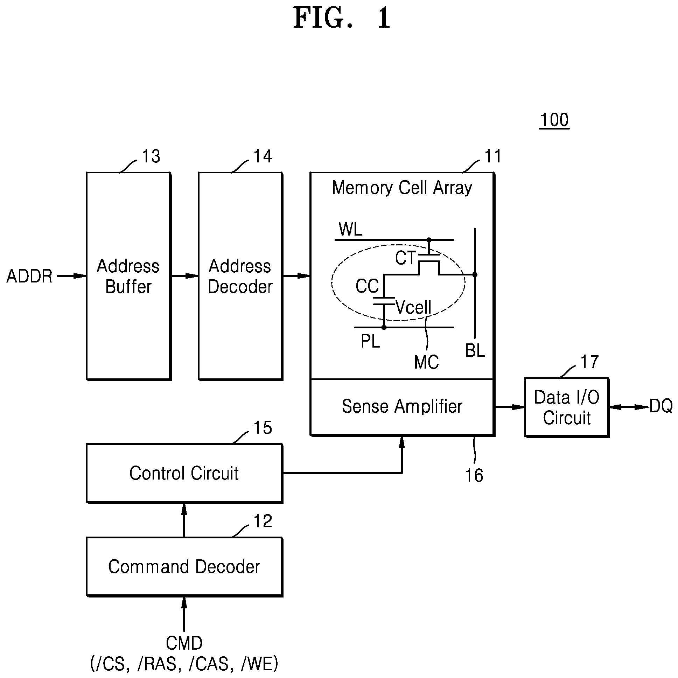

FIG. 1 is a block diagram of a semiconductor memory device 100 according to an embodiment.

Referring to FIG. 1, the semiconductor memory device 100 may include a memory cell array 11, a command decoder 12, an address buffer 13, an address decoder 14, a control circuit 15, a sense amplifier 16, and a data input/output (I/O) circuit 17.

The memory cell array 11 may include a plurality of memory cells MC. The memory cell array 11 may include a plurality of word lines WL, a plurality of bit lines BL, and a plurality of plate electrodes PL, which are connected to the memory cell MC. The memory cell array 11 may include a dynamic random access memory (DRAM) configured to sense, as data, a cell voltage Vcell stored in the memory cell MC.

The semiconductor memory device 100 may receive and output data DQ from and to an external device, in response to a command CMD and an address ADDR, which are received from the external device (e.g., a central processing unit (CPU) or a memory controller).

Each of the plurality of memory cells MC may include a cell transistor CT and a cell capacitor CC. A gate of the cell transistor CT may be connected to the word line WL. A first terminal of the cell transistor CT may be connected to the bit line BL. A second terminal of the cell transistor CT may be connected to a first terminal of the cell capacitor CC. A second terminal of the cell capacitor CC may be connected to the plate electrode PL. The memory cell MC may store, in the cell capacitor CC, a cell voltage Vcell having a magnitude that specifies data.

The command decoder 12 may determine an input command CMD by referring to a chip select signal /CS, a row address strobe signal /RAS, a column address strobe signal /CAS, and a write enable signal /WE, which are applied from the external device. The command decoder 12 may generate control signals corresponding to the command CMD. The command CMD may include an activation command, a read command, a write command, and a precharge command.

The address buffer 13 may receive an address ADDR from the external device. The address ADDR may include a word line address for addressing some of the plurality of word lines WL connected to the memory cell array 11, a bit line address for addressing some of the plurality of bit lines BL connected to the memory cell array 11, and a plate line address for addressing some of the plurality of plate electrodes PL connected to the memory cell array 11. The address buffer 13 may transmit each of the word line address, the bit line address, and the plate line address to the address decoder 14.

The address decoder 14 may include a word line decoder, a bit line decoder, and a plate line decoder, which are respectively configured to select the word line WL, the bit line BL, and the plate electrode PL of the memory cell MC to be accessed, in response to the received address ADDR. The word line decoder may decode the word line address and activate the word line WL of the memory cell MC corresponding to the word line address. The bit line decoder may decode the bit line address and provide a bit line select signal BLS for selecting the bit line BL of the memory cell MC corresponding to the bit line address. The plate line decoder may decode the plate line address and provide a plate line select signal PLS for selecting the plate electrode PL of the memory cell MC corresponding to the plate line address.

The control circuit 15 may control the sense amplifier 16 under the control by the command decoder 12. The control circuit 15 may control an operation of the sense amplifier 16 to detect a cell voltage Vcell of the memory cell MC. The control circuit 15 may control the sense amplifier 16 to perform a precharge operation, a charge sharing operation, and a sense operation.

The sense amplifier 16 may detect charges stored in the memory cell MC as data. Also, the sense amplifier 16 may transmit detected data DQ to the data I/O circuit 17 such that the detected data DQ is output to the outside of the semiconductor memory device 100.

The data I/O circuit 17 may receive data DQ to be written to the memory cell MC from the outside and transmit the data DQ to the memory cell array 11. The data I/O circuit 17 may externally output bit data detected by the sense amplifier 16 as read data.

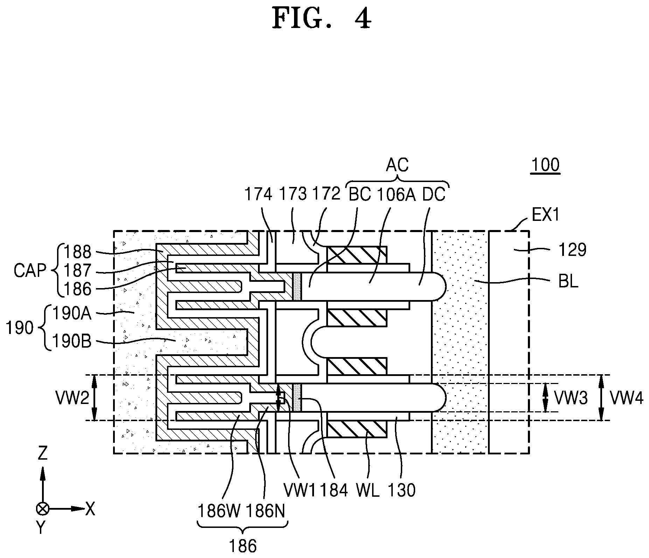

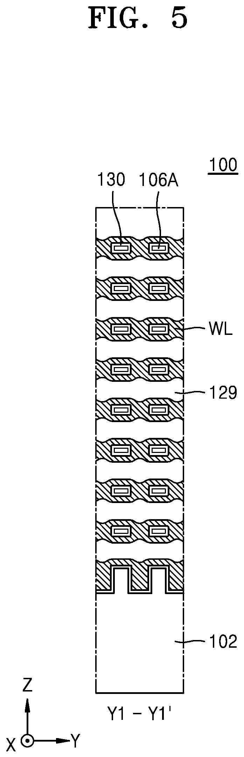

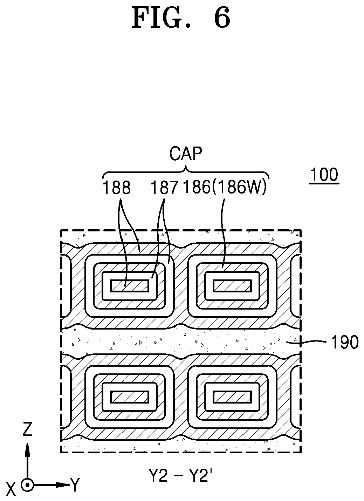

FIGS. 2 to 6 are diagrams of a semiconductor memory device 100 according to embodiments. More specifically, FIG. 2 is a plan view of the semiconductor memory device 100 according to embodiments. FIG. 3 is a cross-sectional taken along line X1 - X1' of FIG. 2. FIG. 4 is an enlarged cross-sectional view of a partial region "EX1" of FIG. 3. FIG. 5 is a cross-sectional taken along line Y1 - Y1' of FIG. 2. FIG. 6 is an enlarged cross-sectional view of some components in a cross-section taken along line Y2 - Y2' of FIG. 2. Components of the semiconductor memory device 100 described below with reference to FIGS. 2 to 6 may constitute a portion of the memory cell array 11 described with reference to FIG. 1.

Referring to FIGS. 2 to 6, the semiconductor memory device 100 may include a memory cell block CB including a plurality of memory cells, which are repeatedly arranged on a substrate 102 in a first lateral direction (X direction) and a second lateral direction (Y direction), which cross (and may be perpendicular) to each other, and a vertical direction (Z direction), which is perpendicular to a main surface 102M of the substrate 102.

At each of a plurality of vertical levels from the substrate 102 in the vertical direction (Z direction), the memory cell block CB may include a plurality of active regions AC, which are repeatedly arranged in the first lateral direction (X direction) and the second lateral direction (Y direction). As shown in FIGS. 3 and 4, the plurality of active regions AC included in the memory cell block CB may include a plurality of active regions AC, which are arranged in a line extending in the vertical direction (Z direction) on the substrate 102 and overlap each other in the vertical direction (Z direction). In embodiments, as shown in FIGS. 3 and 4, each of the plurality of active regions AC included in the memory cell block CB may have a thickness in the vertical direction (Z direction), which is constant in the first lateral direction (X direction).

Each of the plurality of active regions AC may include a channel region 106A and a buried contact BC and a direct contact DC, which are spaced apart from each other in the first lateral direction (X direction) with the channel region 106A therebetween. In each of the plurality of active regions AC, the buried contact BC, the channel region 106A, and the direct contact DC may be sequentially arranged in a straight line extending in the first lateral direction (X direction). In embodiments, each of the plurality of active regions AC may have a thickness in the vertical direction (Z direction), which is substantially constant in the first lateral direction (X direction). In the plurality of active regions AC, respective thicknesses of the buried contact BC, the channel region 106A, and the direct contact DC in the vertical direction (Z direction) may be the same or similar to each other. In embodiments, each of the plurality of active regions AC may include a doped Si layer.

As shown in FIGS. 2, 3, and 4, at each of a plurality of vertical levels from the substrate 102 in the vertical direction (Z direction), the memory cell block CB of the semiconductor memory device 100 may include a plurality of word lines WL, which extend lengthwise in the second lateral direction (Y direction) that is parallel to the main surface 120M of the substrate 102. The plurality of word lines WL may be spaced apart from each other in the first lateral direction (X direction), the second lateral direction (Y direction), and the vertical direction (Z direction). Each of the plurality of word lines WL may surround a channel region 106A, which is a local region of a selected one of the plurality of active regions AC included in the memory cell block CB, and extend lengthwise in the second lateral direction (Y direction). As shown in FIG. 3, the plurality of word lines WL included in the memory cell block CB may include a plurality of word lines WL, which are arranged in a line extending in the vertical direction (Z direction) on the substrate 102 and overlap each other in the vertical direction (Z direction).

In embodiments, each of the plurality of word lines WL may include a metal, a conductive metal nitride, a metal silicide, doped polysilicon, or a combination thereof. For example, each of the plurality of word lines WL may include titanium (Ti), titanium nitride (TiN), tantalum (Ta), tantalum nitride (TaN), molybdenum (Mo), ruthenium (Ru), tungsten (W), tungsten nitride (WN), cobalt (Co), aluminum (Al), nickel (Ni), titanium silicide (TiSi), titanium silicon nitride (TiSiN), tungsten silicide (WSi), tungsten silicon nitride (WSiN), tantalum silicide (TaSi), tantalum silicon nitride (TaSiN), ruthenium titanium nitride (RuTiN), cobalt silicide (CoSi), nickel silicide (NiSi), doped polysilicon, or a combination thereof, without being limited thereto.

A gate dielectric film 130 may be between the channel region 106A of the active region AC and the word line WL. In the first lateral direction (X direction), a width of each of the plurality of gate dielectric films 130 may be greater than a width of each of the plurality of word lines WL. In embodiments, the gate dielectric film 130 may include a paraelectric material. For example, the gate dielectric film 130 may include silicon oxide, silicon nitride, silicon oxynitride, or a combination thereof. In other embodiments, the gate dielectric film 130 may include a high-k dielectric material. The high-k dielectric material may have a dielectric constant of about 10 to about 25. For example, the high-k dielectric material may include hafnium oxide, aluminum oxide, zirconium oxide, or a combination thereof, without being limited thereto. For instance, each of the plurality of gate dielectric films 130 may include HfO₂, Al₂O₃, ZrO₂, or a combination thereof, without being limited thereto. In still other embodiments, the gate dielectric film 130 may include a combination of a paraelectric material and a high-k dielectric material.

As shown in FIGS. 3 and 4, respective spaces of the plurality of word lines WL arranged in a line extending in the vertical direction (Z direction) may be filled by an insulating structure 129. The insulating structure 129 may include a silicon oxide film, a silicon nitride film, or a combination thereof.

As shown in FIGS. 2 to 4, the memory cell block CB of the semiconductor memory device 100 may include a plurality of bit lines BL, which extend lengthwise in the vertical direction (Z direction). On the substrate 102, each of the plurality of bit lines BL may pass through the insulating structure 129 and extend lengthwise in the vertical direction (Z direction). Each of the plurality of bit lines BL may be connected to one end of each of the plurality of active regions AC that overlap each other in the vertical direction (Z direction), from among the plurality of active regions AC included in the memory cell block CB. Each of the plurality of bit lines BL may be connected to the direct contact DC of a selected one of the plurality of active regions AC.

In embodiments, the direct contact DC included in the active region AC may include a doped silicon layer. For example, the direct contact DC may include a silicon layer doped with an n-type dopant. Each of the plurality of bit lines BL may include a metal, a conductive metal nitride, a metal silicide, doped polysilicon, or a combination thereof. For example, each of the plurality of bit lines BL may include Ti, TiN, Ta, TaN, Mo, Ru, W, WN, Co, Al, Ni, TiSi, TiSiN, WSi, WSiN, TaSi, TaSiN, RuTiN, CoSi, NiSi, doped polysilicon, or a combination thereof, without being limited thereto. In embodiments, as shown in FIG. 3, each of the plurality of bit lines BL may include a metal silicide film 152, a conductive liner 154, and a conductive plug 156, which are sequentially stacked on a surface of the direct contact DC of the active region AC. When viewed in an X-Z plane of FIG. 3, the conductive plug 156 may be surrounded by the conductive liner 154, and the conductive plug 156 and the conductive liner 154 may be surrounded by the metal silicide film 152. In embodiments, the metal silicide film 152 may be omitted. In embodiments, the metal silicide film 152 may include molybdenum silicide or titanium silicide, the conductive liner 154 may include TiN, and the conductive plug 156 may include W, without being limited thereto.

As shown in FIGS. 2, 3, and 4, the memory cell block CB of the semiconductor memory device 100 may include a plurality of capacitors CAP respectively connected to the plurality of active regions AC. Each of the plurality of capacitors CAP may include a first electrode 186, a dielectric film 187, and a second electrode 188. The first electrode 186 of the capacitor CAP may be connected to the buried contact BC of a selected one of the plurality of active regions AC. The dielectric film 187 may cover a surface of the first electrode 186. The second electrode 188 may cover the dielectric film 187 and be spaced apart from the first electrode 186 with the dielectric film 187 therebetween.

As shown in FIGS. 3 and 4, the first electrode 186 of each of the plurality of capacitors CAP may be connected to the buried contact BC of the active region AC adjacent thereto. The first electrode 186 may include an electrode support portion 186N and a main electrode portion 186W. The electrode support portion 186N may be adjacent to the buried contact BC of the active region AC. The main electrode portion 186W may be integrally connected to the electrode support portion 186N and be spaced apart from the buried contact BC in the first lateral direction (X direction) with the electrode support portion 186N therebetween. In the vertical direction (Z direction), the electrode support portion 186N may have a first width VW1, and the main electrode portion 186W may have a second width VW2, which is greater than the first width VW1.

In each of the plurality of capacitors CAP, each of the electrode support portion 186N and the main electrode portion 186W of the first electrode 186 may have a cylindrical shape defining an inner space that accommodates a portion of the dielectric film 187. An outer surface of the electrode support portion 186N of the first electrode 186 may be spaced apart from the dielectric film 187 with an insulating film 174 therebetween. An outer surface of the main electrode portion 186W of the first electrode 186 may be in contact with the dielectric film 187.

The semiconductor memory device 100 may include an insulating liner 172 surrounding the buried contact BC, a buried insulating film 173 surrounding the insulating liner 172, and an insulating film 174 covering a surface facing the dielectric film 187 and the second electrode 188, from among surfaces of the buried insulating film 173. The insulating film 174 may include a portion in contact with the electrode support portion 186N of the first electrode 186 and a portion in contact with the buried insulating film 173. A portion of the insulating film 174 may surround the electrode support portion 186N of the first electrode 186. The insulating liner 172 may be in contact with the electrode support portion 186N of the first electrode 186 and the buried contact BC. The insulating liner 172 may cover a sidewall of the word line WL. A portion of the insulating liner 172, which surrounds the buried contact BC, a portion of the insulating film 174, which surrounds the electrode support portion 186N of the first electrode 186, and the gate dielectric film 130 may be collinear with each other in the first lateral direction (X direction). In embodiments, each of the insulating liner 172 and the insulating film 174 may include silicon oxide, and the buried insulating film 173 may include silicon nitride, without being limited thereto.

The electrode support portion 186N of the first electrode 186 may protrude in the first lateral direction (X direction) toward the buried contact BC of the active region AC further than the dielectric film 187. The electrode support portion 186N of the first electrode 186 and the buried contact BC of the active region AC may be surrounded by the insulating liner 172.

A metal silicide film 184 may be between the electrode support portion 186N of the first electrode 186 and the buried contact BC of the active region AC. The metal silicide film 184 may be in contact with each of the electrode support portion 186N and the buried contact BC. The metal silicide film 184 may be surrounded by the insulating liner 172 together with the electrode support portion 186N and the buried contact BC. The metal silicide film 184 may include titanium silicide, tantalum silicide, cobalt silicide, molybdenum silicide, or tungsten silicide, without being limited thereto. The first electrode 186 of the capacitor CAP may be electrically connected to the buried contact BC of the active region AC through the metal silicide film 184. In embodiments, the metal silicide film 184 may be omitted. In this case, the electrode support portion 186N included in the first electrode 186 of the capacitor CAP may be in contact with the buried contact BC of the active region AC. The second electrode 188 of the capacitor CAP may be spaced apart from the active region AC and cover a surface of the first electrode 186.

As shown in FIG. 2, in a view from above, the plurality of capacitors CAP may be adjacent to the plurality of word lines WL and the plurality of active regions AC and be arranged in a line extending in the second lateral direction (Y direction). As used herein, the view from above means a view from the X-Y plane. In a view from above, each of the plurality of active regions AC may be between the bit line BL and the capacitor CAP, each of which is adjacent thereto, in the first lateral direction (X direction). As shown in FIGS. 2 and 3, the plurality of bit lines BL may be spaced apart from the plurality of capacitors CAP in the first lateral direction (X direction) with the plurality of word lines WL therebetween.

In each of the plurality of capacitors CAP, the electrode support portion 186N and the main electrode portion 186W of the first electrode 186 may be integrally connected to each other and include the same material. In each of the plurality of capacitors CAP, each of the electrode support portion 186N and the main electrode portion 186W, which are included in the first electrode 186 and the second electrode 188 may include a metal film, a conductive metal oxide film, a conductive metal nitride film, a conductive metal oxynitride film, or a combination thereof. In embodiments, each of the first electrode 186 and the second electrode 188 may include molybdenum (Mo), tungsten (W), ruthenium (Ru), platinum (Pt), iridium (Ir), cobalt (Co), tin (Sn), titanium (Ti), a Ti nitride, a Ti oxide, a Ti oxynitride, niobium (Nb), a Nb nitride, a Nb oxide, a Nb oxynitride, a tungsten (W) nitride, a vanadium (V) nitride, a V oxide, a molybdenum (Mo) nitride, a Mo oxide, a ruthenium (Ru) oxide, a strontium ruthenium (SrRu) oxide, a cobalt (Co) nitride, a Co oxide, a Co oxynitride, a tin (Sn) nitride, a Sn oxide, a Sn oxynitride, or a combination thereof. For example, each of the first electrode 186 and the second electrode 188 may include titanium nitride (TiN), niobium nitride (NbN), cobalt nitride (CoN), tin oxide (SnO₂), or a combination thereof. In other embodiments, each of the first electrode 186 and the second electrode 188 may include tantalum nitride (TaN), titanium aluminum nitride (TiAlN), tantalum aluminum nitride (TaAlN), vanadium (V), vanadium nitride (VN), molybdenum (Mo), molybdenum nitride (MoN), tungsten (W), tungsten nitride (WN), ruthenium (Ru), ruthenium oxide (RuO₂), strontium ruthenium oxide (SrRuO₃, SRO), iridium (Ir), iridium oxide (IrO₂), platinum (Pt), platinum oxide (PtO), (Ba,Sr)RuO₃ (BSRO), CaRuO₃ (CRO), (La,Sr)CoO₃) (LSCo), or a combination thereof. However, a constituent material of each of the first electrode 186 and the second electrode 188 is not limited to the examples described above.

The dielectric film 187 may include a silicon oxide film, a high-k dielectric film, or a combination thereof. In embodiments, the dielectric film 187 may include a metal oxide including at least one metal selected from hafnium (Hf), zirconium (Zr), aluminum (Al), niobium (Nb), cerium (Ce), lanthanum (La), tantalum (Ta), and titanium (Ti). In embodiments, the dielectric film 187 may have a single film structure including one high-k dielectric film. In other embodiments, the dielectric film 187 may have a multilayered structure including a plurality of high-k dielectric films sequentially stacked on the first electrode 186. The high-k dielectric films may include a HfO₂ film, a ZrO₂ film, an Al₂O₃ film, a Y₂O₃ film, a Sc₂O₃ film, a La₂O₃ film, a Ta₂O₅ film, a Nb₂O₅ film, a CeO₂ film, a TiO₂ film, a GeO₂ film, a SrTiO₃ film, a BaSrTiO₃ film, or a combination thereof, without being limited thereto. In other embodiments, the dielectric film 187 may include an oxide of at least one metal selected from Ti, Nb, Ta, Sn, and Mo or an oxynitride of at least one metal selected from Ti, Nb, Ta, Sn, and Mo. For example, the dielectric film 187 may include a Ti oxide, a Ti oxynitride, a Nb oxide, a Nb oxynitride, a Ta oxide, a Ta oxynitride, a Sn oxide, a Sn oxynitride, a Mo oxide, a Mo oxynitride, or a combination thereof. In still other embodiments, the dielectric film 187 may include a ferroelectric film, which includes at least one oxide selected from hafnium (Hf), silicon (Si), aluminum (Al), zirconium (Zr), yttrium (Y), lanthanum (La), gadolinium (Gd), and strontium (Sr). The ferroelectric film may include a hafnium-based oxide, for example, hafnium oxide (HfO), hafnium zirconium oxide (HZO), hafnium titanium oxide, or hafnium silicon oxide. The ferroelectric film may further include a dopant as needed. The dopant may include at least one element selected from silicon (Si), aluminum (Al), zirconium (Zr), yttrium (Y), lanthanum (La), gadolinium (Gd), scandium (Sc), strontium (Sr), magnesium (Mg), and barium (Ba), without being limited thereto.

In each of the plurality of capacitors CAP, the dielectric film 187 may cover an inner surface and an outer surface of the main electrode portion 186W of the first electrode 186. Each of the inner surface and the outer surface of the main electrode portion 186W may be in contact with the dielectric film 187. The dielectric film 187 may cover an inner surface of the electrode support portion 186N of the first electrode 186 without covering an outer surface of the electrode support portion 186N of the first electrode 186. The inner surface of the electrode support portion 186N may be in contact with the dielectric film 187, and the outer surface of the electrode support portion 186N may be in contact with the insulating liner 172. The outer surface of the electrode support portion 186N may be spaced apart from the dielectric film 187 with the insulating film 174 therebetween.

The electrode support portion 186N of the first electrode 186 may be aligned and collinear with the buried contact BC, the channel region 106A, and the direct contact DC, which are included in the active region AC, in the first lateral direction (X direction). In the vertical direction (Z direction), the first width VW1 of the electrode support portion 186N may be substantially equal to a third width VW3 of the active region AC.

The gate dielectric film 130 may be between the channel region 106A of the active region AC and the word line WL, and may surround the channel region 106A. The first width VW1 of the electrode support portion 186N of the first electrode 186 may be less than a fourth width VW4, which is a greatest width of the gate dielectric film 130 in the vertical direction (Z direction). The fourth width VW4 may be defined by an outer surface of the gate dielectric film 130.

As shown in FIG. 6, when viewed in a Y-Z plane, a cross-section of the main electrode portion 186W of the first electrode 186 may have a tetragonal closed loop shape with round corners. The dielectric film 187 may be in contact with each of the inner surface and the outer surface of the main electrode portion 186W of the first electrode 186. A portion of the second electrode 188 may fill a portion defined by the dielectric film 187 in an inner space of the first electrode 186, and another portion of the second electrode 188 may cover an outer surface of the first electrode 186 with the dielectric film 187 therebetween.

As shown in FIGS. 2 and 3, the memory cell block CB of the semiconductor memory device 100 may further include a plate electrode 190. The plate electrode 190 may correspond to the plate electrode PL described with reference to FIG. 1. As shown in FIG. 3, the plate electrode 190 may include a center portion 190A and a plurality of finger portions 190B. The center portion 190A may extend lengthwise in the vertical direction (Z direction) on the substrate 102. The plurality of finger portions 190B may protrude from the center portion 190A in the first lateral direction (X direction). Each of the plurality of finger portions 190B of the plate electrode 190 may overlap the main electrode portion 186W of the first electrode 186 of the capacitor CAP in the vertical direction (Z direction). The plurality of finger portions 190B of the plate electrode 190 may not overlap the electrode support portion 186N of the first electrode 186 of the capacitor CAP in the vertical direction (Z direction). The plurality of finger portions 190B of the plate electrode 190 may be spaced apart from the main electrode portion 186W of the first electrode 186 in the vertical direction (Z direction) with the dielectric film 187 and the second electrode 188) of the capacitor CAP therebetween. A plurality of capacitors CAP located on both sides of one plate electrode 190 in the first lateral direction (X direction) may share the one plate electrode 190. The plate electrode 190 may include a metal film, a conductive metal oxide film, a conductive metal nitride film, a conductive metal oxynitride film, semiconductor film, or a combination thereof. In embodiments, the plate electrode 190 may include Ti, a Ti nitride, a Ti oxide, a Ti oxynitride, Nb, a Nb nitride, a Nb oxide, a Nb oxynitride, Co, a Co nitride, a Co oxide, a Co oxynitride, Sn, a Sn nitride, a Sn oxide, a Sn oxynitride, silicon germanium (SiGe), or a combination thereof. For example, the plate electrode 190 may include titanium nitride (TiN), niobium nitride (NbN), tantalum nitride (TaN), titanium aluminum nitride (TiAlN), tantalum aluminum nitride (TaAlN), vanadium (V), vanadium nitride (VN), molybdenum (Mo), molybdenum nitride (MoN), tungsten (W), tungsten nitride (WN), ruthenium (Ru), iridium (Ir), platinum (Pt), silicon germanium (SiGe), or a combination thereof, without being limited thereto.

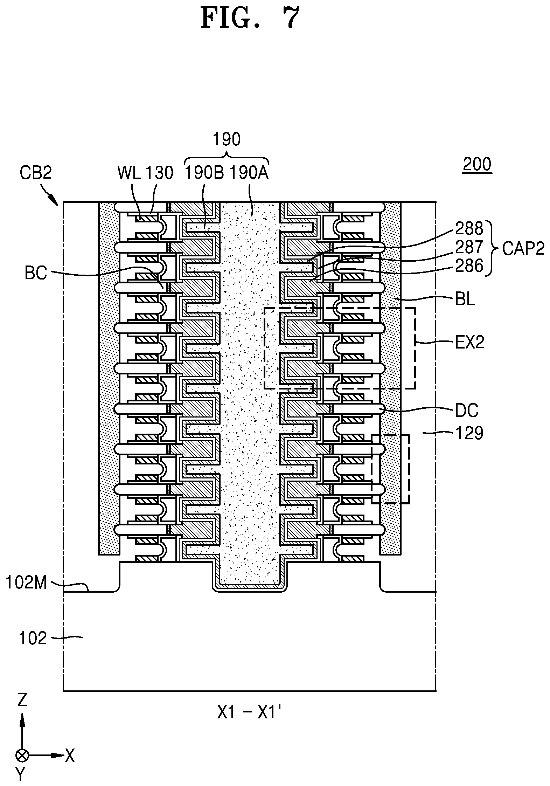

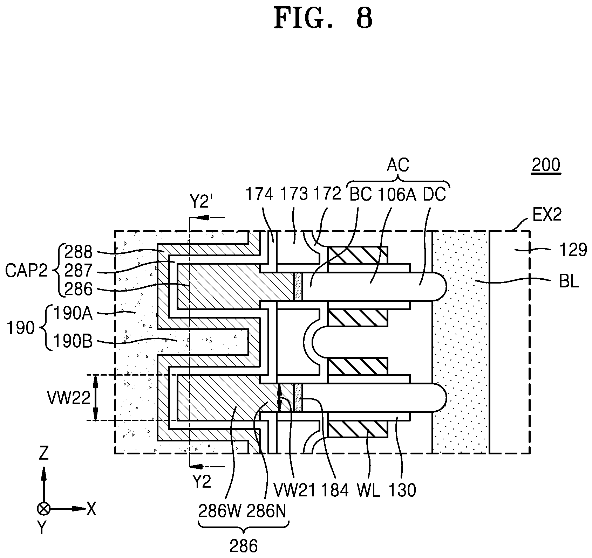

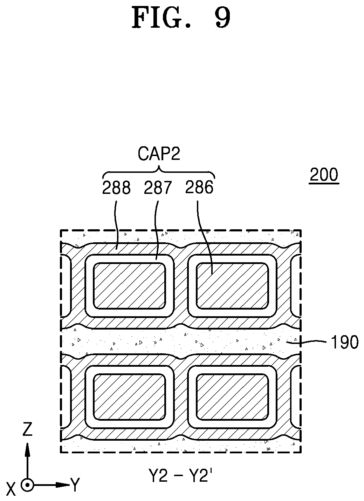

FIGS. 7 to 9 are diagrams of a semiconductor memory device 200 according to embodiments. More specifically, FIG. 7 is a cross-sectional view of a portion of the semiconductor memory device 200, which corresponds to a cross-section taken along line X1 - X1' of FIG. 2. FIG. 8 is an enlarged cross-sectional view of a partial region "EX2" of FIG. 7. FIG. 9 is an enlarged cross-sectional view of some components in a cross-section taken along line Y2 - Y2' of FIG. 8. Components of the semiconductor memory device 200 described below with reference to FIGS. 7 to 9 may constitute a portion of the memory cell array 11 described with reference to FIG. 1. In FIGS. 7 to 9, the same reference numerals are used to denote the same elements as in FIGS. 2 to 6, and thus, repeated descriptions thereof are omitted.

Referring to FIGS. 7 to 9, a memory cell block CB2 of the semiconductor memory device 200 may substantially have the same configuration as the memory cell block CB of the semiconductor memory device 100, which has been described with reference to FIGS. 2 to 6. However, the memory cell block CB2 of the semiconductor memory device 200 may include a plurality of capacitors CAP2 respectively connected to a plurality of active regions AC. Each of the plurality of capacitors CAP2 may include a first electrode 286, a dielectric film 287, and a second electrode 288. The first electrode 286 of the capacitor CAP2 may be connected to a buried contact BC of a selected one of the plurality of active regions AC. The first electrode 286, the dielectric film 287, and the second electrode 288 of each of the plurality of capacitors CAP2 may respectively and substantially have the same configurations as the first electrode 186, the dielectric film 187, and the second electrode 188, which have been described with reference to FIGS. 2 to 4. However, the first electrode 286 of each of the plurality of capacitors CAP2 may include an electrode support portion 286N and a main electrode portion 286W. The electrode support portion 286N may be adjacent to the buried contact BC of the active region AC. The main electrode portion 286W may be integrally connected to the electrode support portion 286N and be spaced apart from the buried contact BC in a first lateral direction (X direction) with the electrode support portion 286N therebetween. In the vertical direction (Z direction), the electrode support portion 286N may have a first width VW21, and the main electrode portion 286W may have a second width VW22, which is greater than the first width VW21.

In each of the plurality of capacitors CAP2, each of the electrode support portion 286N and the main electrode portion 286W of the first electrode 286 may have a pillar shape with filled interior. An outer surface of the electrode support portion 286N of the first electrode 286 may be spaced apart from the dielectric film 287 with the insulating film 174 therebetween, and an outer surface of the main electrode portion 286W of the first electrode 286 may be in contact with the dielectric film 287.

As shown in FIG. 9, when viewed in a Y-Z plane, a cross-section of the first electrode 286 may have a tetragonal shape with round corners. The dielectric film 287 may be in contact with an outer surface of the first electrode 286. The second electrode 288 may cover the outer surface of the first electrode 286 with the dielectric film 287 therebetween.

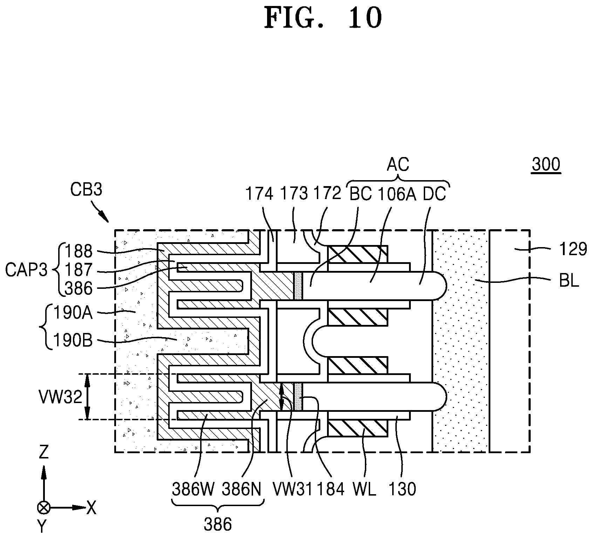

FIG. 10 is a cross-sectional view of a semiconductor memory device 300 according to embodiments. FIG. 10 illustrates a cross-sectional configuration of a portion of the semiconductor memory device 300, which corresponds to a cross-section taken along line X1-X1' of FIG. 2. Components of the semiconductor memory device 300 described below with reference to FIG. 10 may constitute a portion of the memory cell array 11 described with reference to FIG. 1. In FIG. 10, the same reference numerals are used to denote the same elements as in FIGS. 2 to 6, and thus, repeated descriptions thereof are omitted.

Referring to FIG. 10, a memory cell block CB3 of the semiconductor memory device 300 may substantially have the same configuration as the memory cell block CB of the semiconductor memory device 100, which has been described with reference to FIGS. 2 to 6. However, the memory cell block CB3 of the semiconductor memory device 300 may include a plurality of capacitors CAP3 respectively connected to a plurality of active region AC. Each of the plurality of capacitors CAP3 may include a first electrode 386, a dielectric film 187, and a second electrode 188. The first electrode 386 of the capacitor CAP3 may be connected to the buried contact BC of a selected one of the plurality of active regions AC. The first electrode 386 of each of the plurality of capacitors CAP3 may substantially have the same configuration as the first electrode 186 described with reference to FIGS. 2 to 4. However, the first electrode 386 of each of the plurality of capacitors CAP3 may include an electrode support portion 386N and a main electrode portion 386W. The electrode support portion 386N may be adjacent to the buried contact BC of the active region AC. The main electrode portion 386W may be integrally connected to the electrode support portion 386N and be spaced apart from the buried contact BC in a first lateral direction (X direction) with the electrode support portion 386N therebetween. In a vertical direction (Z direction), the electrode support portion 386N may have a first width VW31, and the main electrode portion 386W may have a second width VW32, which is greater than the first width VW31.

In each of the plurality of capacitors CAP3, the electrode support portion 386N of the first electrode 386 may have a pillar shape with filled interior, and the main electrode portion 386W of the first electrode 386 may have a cylindrical shape defining an inner space that accommodates a portion of the dielectric film 187 and a portion of the second electrode 188. An outer surface of the electrode support portion 386N of the first electrode 386 may be spaced apart from the dielectric film 187 with an insulating film 174 therebetween, and an outer surface of the main electrode portion 386W of the first electrode 386 may be in contact with the dielectric film 187.

In the semiconductor memory devices 100, 200, and 300 described with reference to FIGS. 1 to 10, the first electrodes 186, 286, and 386 of the capacitors CAP, CAP2, and CAP3 may respectively include the electrode support portions 186N, 286N, and 386N and the main electrode portions 186W, 286W, and 386W. The electrode support portions 186N, 286N, and 386N may each be connected to the buried contact BC of the active region AC and have the first width VW1 in the vertical direction (Z direction). The main electrode portions 186W, 286W, and 386W may be integrally connected to the electrode support portions 186N, 286N, and 386N, respectively, and each may be spaced apart from the buried contact BC in the first lateral direction (X direction) with the electrode support portions 186N, 286N, and 386N therebetween. The main electrode portions 186W, 286W, and 386W may each have a second width VW2, which is greater than the first width VW1 in the vertical direction (Z direction). The electrode support portions 186N, 286N, and 386N of the first electrodes 186, 286, and 386 may each have a structure surrounded by the insulating liner 172 along with the buried contact BC of the active region AC. Thus, positions of the electrode support portions 186N, 286N, and 386N, which are respectively portions of the first electrodes 186, 286, and 386, may each be fixed by the insulating liner 172. Accordingly, even when the lengths of the first electrodes 186, 286, and 386 of the capacitors CAP, CAP2, and CAP3 in the first lateral direction (X direction) are increased to improve capacitance, the occurrence of undesired deformation, such as the leaning, bending, or collapse of the first electrodes 186, 286, and 386, and defects caused by the undesired deformation may be prevented during the manufacture of the semiconductor memory devices 100, 200, and 300. Therefore, the semiconductor memory devices 100, 200, and 300 according to embodiments may maximize the capacitances of the capacitors CAP, CAP2, and CAP3 in limited areas. In addition, the semiconductor memory devices 100, 200, and 300 according to embodiments may have improved performance without inefficiently increasing the area occupied by the plurality of memory cells in the memory cell blocks CB, CB2, and CB3, and provide a structure that is advantageous for high integration.

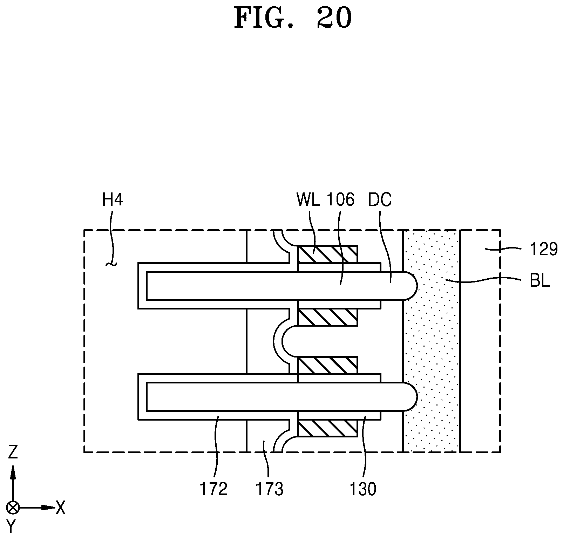

FIGS. 11 to 33B are diagrams of a method of manufacturing a semiconductor memory device, according to embodiments. More specifically, FIGS. 11, 12, 13, 14, 15A, 16A, 17A, 18, and 19A are each a cross-sectional view of a partial region corresponding to a cross-section taken along line X1 - X1' of FIG. 2, according to a process sequence. FIGS. 15B, 16B, and 17B are each a cross-sectional view of a partial region corresponding to a cross-section taken along line Y1 - Y1' of FIG. 2. FIG. 19B is an enlarged cross-sectional view of a partial region "EXB" of FIG. 19A. FIGS. 20, 21, 22, 23, 24, 25, 26, 27, 28, 29, 30, 31, 32A, and 33A are each an enlarged cross-sectional view of a region corresponding to the partial region "EX1" of FIG. 3, according to the process sequence. FIGS. 32B and 33B are each a cross-sectional view of a partial region corresponding to a cross-section taken along line Y2-Y2' of FIG. 2, according to the process sequence. An example of a method of manufacturing the semiconductor memory device 100 described with reference to FIGS. 2 to 6 is described with reference to FIGS. 11 to 33B. In FIGS. 11 to 36B, the same reference numerals are used to denote the same elements as in FIGS. 2 to 6, and thus, repeated descriptions thereof are omitted.

Referring to FIG. 11, a plurality of sacrificial layers 104 and a plurality of active layers 106 may be alternately stacked, one-by-one on a main surface 102M of a substrate 102, in a vertical direction (Z direction). In embodiments, the plurality of sacrificial layers 104 and the plurality of active layers 106 may each include a semiconductor material. In embodiments, each of the plurality of sacrificial layers 104 may include an undoped SiGe layer or a SiGe layer doped with carbon (C) atoms, and each of the plurality of active layers 106 may include a Si layer. In the vertical direction (Z direction), a thickness T1 of each of the plurality of active layers 106 may be less than a thickness T2 of each of the plurality of sacrificial layers 104. In embodiments, the thickness T2 of each of the plurality of sacrificial layers 104 may be at least three times greater than the thickness T1 of each of the plurality of active layers 106, without being limited thereto.

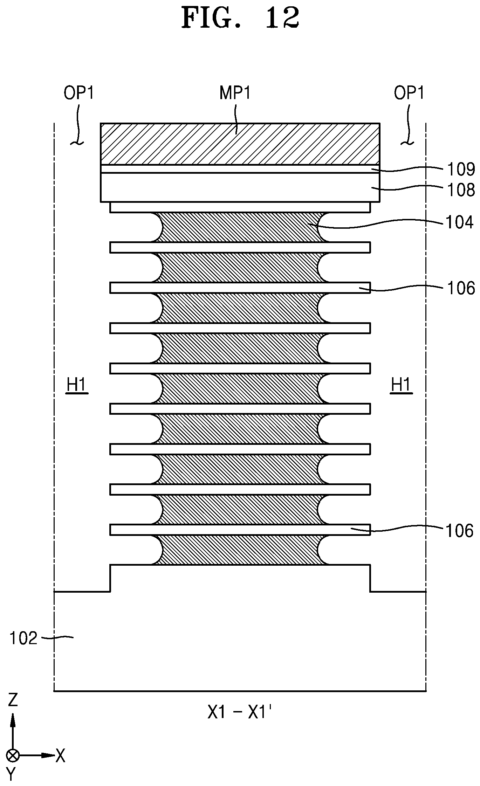

Referring to FIG. 12, a silicon oxide film 108 and a silicon nitride film 109 may be sequentially formed on a stack structure including the plurality of sacrificial layers 104 and the plurality of active layers 106, and a mask pattern MP1 may be formed on the silicon nitride film 109. The mask pattern MP1 may include a plurality of first openings OP1. In embodiments, the mask pattern MP1 may include a photoresist pattern and the plurality of first openings OP1 may correspond to openings in the photoresist pattern, without being limited thereto. Thereafter, the silicon nitride film 109 and the silicon oxide film 108 may be sequentially etched through the plurality of first openings OP1 by using the mask pattern MP1 as an etch mask. Subsequently, the stack structure including the plurality of sacrificial layers 104 and the plurality of active layers 106 may be etched, and thus, a plurality of holes H1 may be formed in the stack structure to expose the substrate 102.

Portions of the plurality of sacrificial layers 104 may be removed through the plurality of first openings OP1 and the plurality of holes H1. As a result, the plurality of active layers 106 may protrude in a first lateral direction (X direction) between the remaining portions of the plurality of sacrificial layers 104.

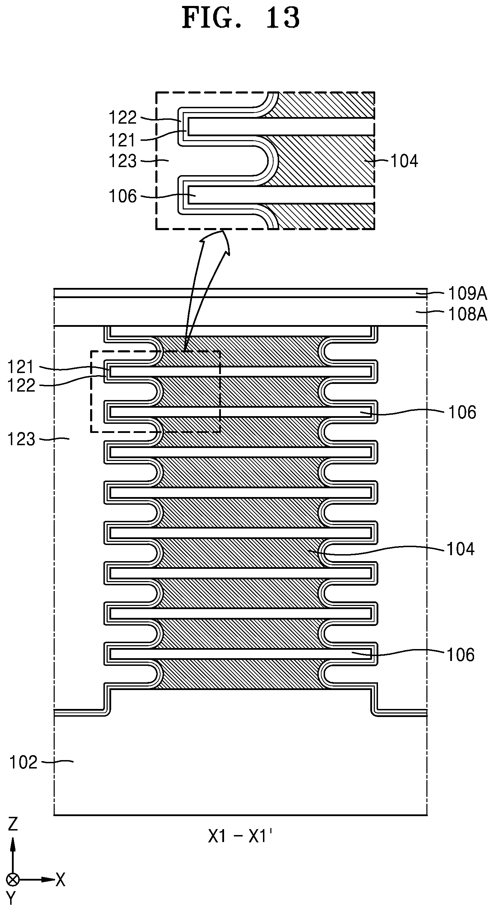

Referring to FIG. 13, in the resultant structure of FIG. 12, a first insulating liner 121 may be formed to conformally cover surfaces exposed through the plurality of holes H1, and a second insulating liner 122 may be formed to conformally cover the first insulating liner 121. A buried insulating film 123 may be formed to fill the remaining spaces of the plurality of holes H1, which are defined by the second insulating liner 122. In embodiments, the first insulating liner 121 may include silicon oxide, the second insulating liner 122 may include silicon nitride, and the buried insulating film 123 may include silicon oxide.

The mask pattern MP1, the silicon nitride film 109, and the silicon oxide film 108 may be removed by using a chemical mechanical polishing (CMP) process. Thus, a planar top surface at which a plurality of active layers 106 located at a farthest vertical level from the substrate 102, from among the plurality of active layers 106, are exposed may be formed. Thereafter, a silicon oxide film 108A and a silicon nitride film 109A may be formed on the obtained resultant structure.

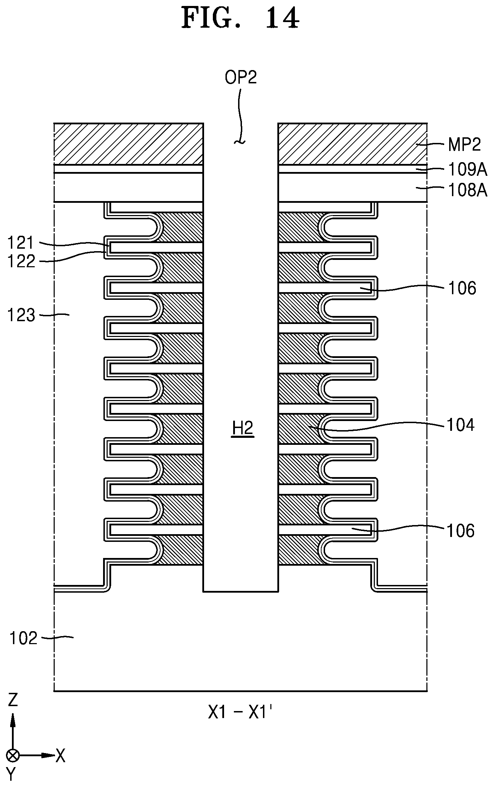

Referring to FIG. 14, a mask pattern MP2 may be formed on the silicon nitride film 109A. The mask pattern MP2 may include a second opening OP2. The second opening OP2 may be located at a position shifted in the first lateral direction (X direction) from positions of the plurality of first openings OP1 formed in the mask pattern MP1 shown in FIG. 12. In embodiments, the mask pattern MP2 may include a photoresist pattern and the second opening OP2 may correspond to an opening in the photoresist pattern, without being limited thereto.

The stack structure including the plurality of sacrificial layers 104 and the plurality of active layers 106 may be etched through the second opening OP2 by using the mask pattern MP2 as an etch mask, and thus, a hole H2 may be formed in the stack structure to expose the substrate 102.

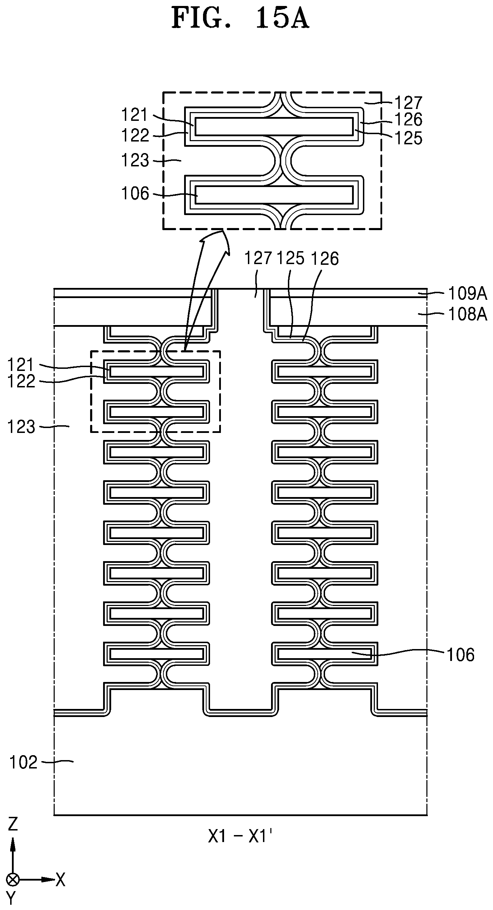

Referring to FIGS. 15A and 15B, in the resultant structure of FIG. 14, the plurality of sacrificial layers 104, which are exposed through a plurality of holes H2, may be removed. During the removal of the plurality of sacrificial layers 104, respective portions of the plurality of active layers 106 may be consumed. Thereafter, a third insulating liner 125 and a fourth insulating liner 126 may be formed to conformally cover surfaces of the plurality of active layers 106, which are exposed through the plurality of holes (refer to H2 in FIG. 14). A buried insulating film 127 may be formed to fill the remaining spaces of the plurality of holes H2, which are defined by the fourth insulating liner 126. In embodiments, the third insulating liner 125 may include silicon oxide, the fourth insulating liner 126 may include silicon nitride, and the buried insulating film 127 may include silicon oxide. The mask pattern MP2 may be removed using a CMP process to expose a top surface of the silicon nitride film 109A.

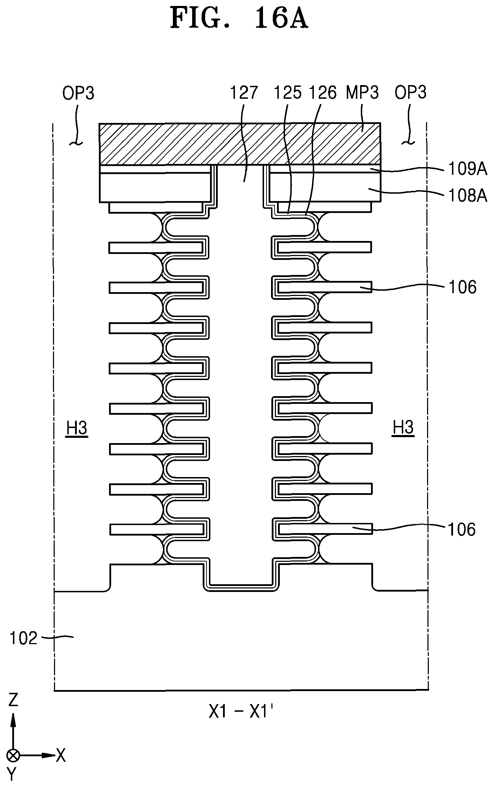

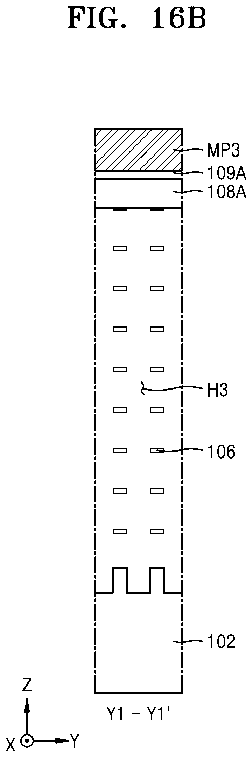

Referring to FIGS. 16A and 16B, a mask pattern MP3 may be formed on the resultant structure on which the processes described with reference to FIGS. 15A and 15B have been performed. The mask pattern MP3 may include a plurality of third openings OP3. The mask pattern MP3 may include a photoresist pattern and the plurality of third openings OP2 may correspond to openings in the photoresist pattern, without being limited thereto.

Thereafter, the silicon nitride film 109A and the silicon oxide film 108A may be sequentially etched through the plurality of third openings OP3 by using the mask pattern MP3 as an etch mask. Subsequently, the buried insulating film 123, the second insulating liner 122, and the first insulating liner 121 may be sequentially removed to form a plurality of holes H3 exposing the plurality of active layers 106 and the substrate 102.

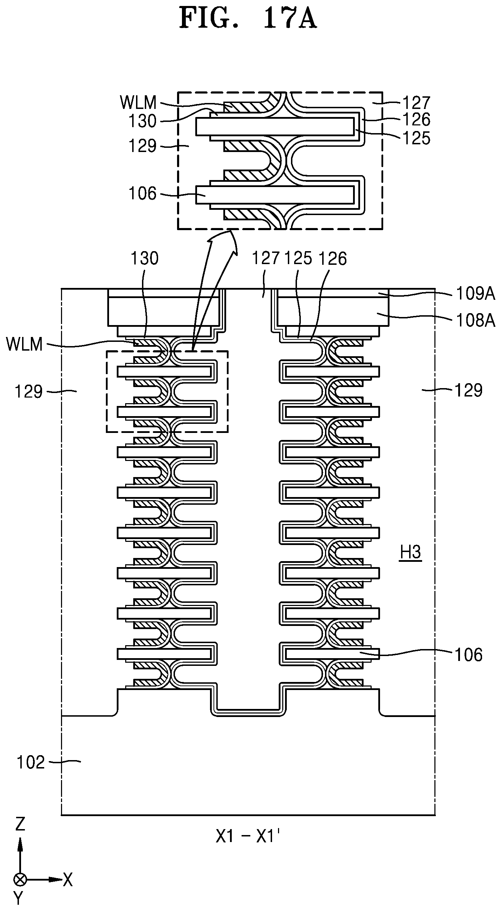

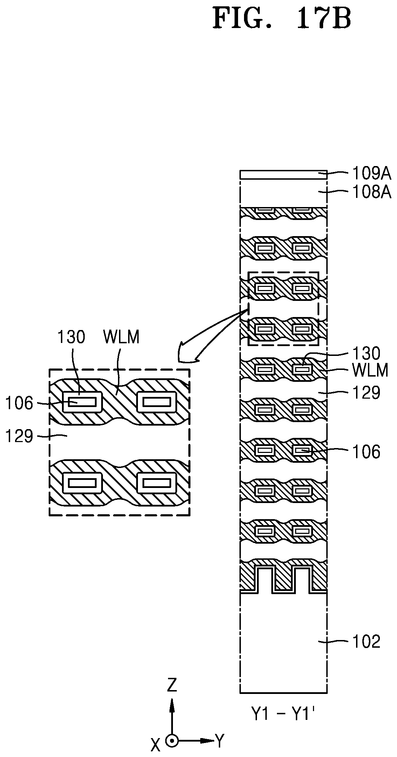

Referring to FIGS. 17A and 17B, the mask pattern MP3 may be removed from the resultant structure of FIGS. 16A and 16B to expose the top surface of the silicon nitride film 109A. Next, a gate dielectric film 130 may be formed to conformally cover surfaces exposed by the plurality of holes H3, a conductive layer may be formed to cover a surface of the gate dielectric film 130, and a protective pattern may be formed to cover portions desired to be left, of the conductive layer. Thereafter, exposed portions of the conductive layer may be selectively removed by using the protective pattern as an etch mask, and thus, a plurality of conductive patterns WLM for forming a plurality of word lines may be formed. Subsequently, the remaining spaces of the plurality of holes H3 by which the plurality of conductive patterns WLM are exposed may be filled by an insulating structure 129. The insulating structure 129 may include a silicon oxide film, a silicon nitride film, or a combination thereof. In embodiments, the insulating structure 129 may include a silicon oxide liner, a silicon nitride liner, and a silicon oxide film for filling, which are sequentially stacked on surfaces of the gate dielectric film 130 and the plurality of conductive patterns WLM. The top surface of the silicon nitride film 109A may be exposed around the insulating structure 129.

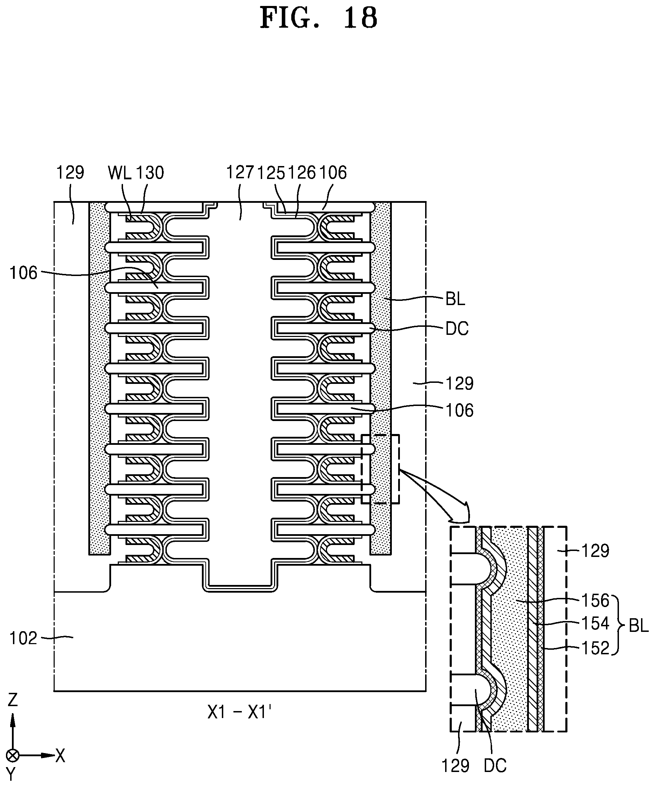

Referring to FIG. 18, in the resultant structure on which the processes described with reference to FIGS. 17A and 17B have been performed, a plurality of bit lines BL may be formed to pass through a portion of the insulating structure 129 in the vertical direction (Z direction). Each of the plurality of bit lines BL may be formed to contact a plurality of active layers 106, which are arranged in a line extending in the vertical direction (Z direction). To form the plurality of bit lines BL, a plurality of vertical holes may be formed to pass through a portion of the insulating structure 129 in the vertical direction (Z direction). The plurality of active layers 106, which are arranged in a line extending in the vertical direction (Z direction), may be exposed through the plurality of vertical holes. A dopant may be doped into each of the plurality of active layers 106 exposed through the plurality of vertical holes to form direct contacts DC. Thereafter, a metal silicide film 152, a conductive liner 154, and a conductive plug 156 may be sequentially formed inside the plurality of vertical holes. The dopant may include p-type or n-type impurity ions. For example, the dopant may include boron (B), phosphorus (P), or arsenic (As), without being limited thereto. The silicon nitride film 109A and the silicon oxide film 108A may be removed by using a CMP process. Subsequently, a planar top surface at which a plurality of active layers 106 located at a farthest vertical level from the substrate 102, from among the plurality of active layers 106, are exposed may be formed.

Referring to FIGS. 19A and 19B, a mask pattern 160 may be formed to cover the resultant structure on which the processes described with reference to FIG. 18 have been performed. The mask pattern 160 may include a fourth opening OP4. In a view from above, a position of the fourth opening OP4 may be the same as or similar to the position of the second opening OP2 shown in FIG. 14. The mask pattern 160 may include a silicon nitride film and the fourth opening OP4 may correspond to an opening in the silicon nitride film.

The buried insulating film 127, the fourth insulating liner 126, and the third insulating liner 125 (refer to FIG. 18) may be removed through the fourth opening OP4. Thus, a hole H4 exposing the plurality of active layers 106, a plurality of gate dielectric films 130, and the substrate 102 may be formed. Thereafter, exposed portions of the plurality of gate dielectric films 130 may be partially removed through the hole H4 to expose the plurality of conductive patterns WLM. Respective portions of the plurality of conductive patterns WLM, which are exposed, may be etched to form a plurality of word lines WL from the plurality of conductive patterns WLM. As a result, as shown in the enlarged view of FIG. 19B, the insulating structure 129 may be exposed around the word line WL surrounding the active layer 106 inside the hole H4.

Referring to FIG. 20, an insulating liner 172 may be formed to conformally cover a surface of each of the plurality of word lines WL, the plurality of gate dielectric films 130, and the insulating structure 129, which are exposed inside the hole H4. Thereafter, a buried insulating film 173 may be formed on the insulating liner 172 to partially fill respective spaces between the plurality of active layers 106. The buried insulating film 173 may be formed to surround a portion of each of the plurality of active layers 106 with the insulating liner 172 therebetween. Portions of the plurality of active layers 106 and the insulating liner 172 covering the plurality of active layers 106 may protrude in the first lateral direction (X direction) over a sidewall of the buried insulating film 173 inside the hole H4.

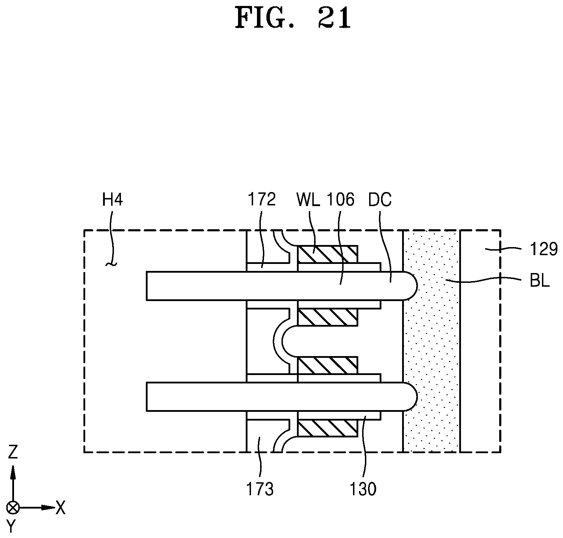

Referring to FIG. 21, in the resultant structure of FIG. 20, a portion of the insulating liner 172 exposed inside the hole H4 may be removed to expose a portion of each of the plurality of active layers 106.

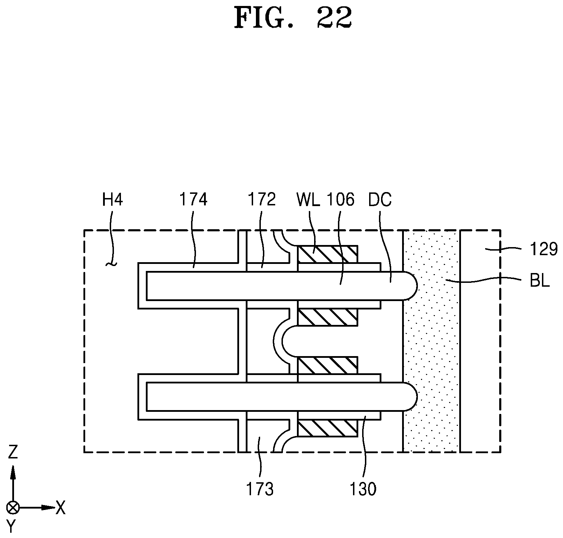

Referring to FIG. 22, in the resultant structure of FIG. 21, an insulating film 174 may be formed to conformally cover each of exposed surfaces of the plurality of active layers 106, exposed surfaces of the insulating liner 172, and exposed surfaces of the buried insulating film 173, from among surfaces exposed by the hole H4. In embodiments, the insulating film 174 may include a silicon oxide film.

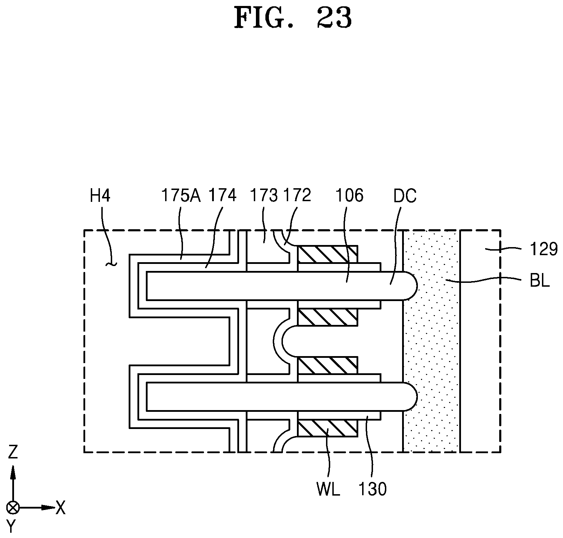

Referring to FIG. 23, on the resultant structure of FIG. 22, a first silicon nitride liner 175A may be formed to conformally cover the insulating film 174.

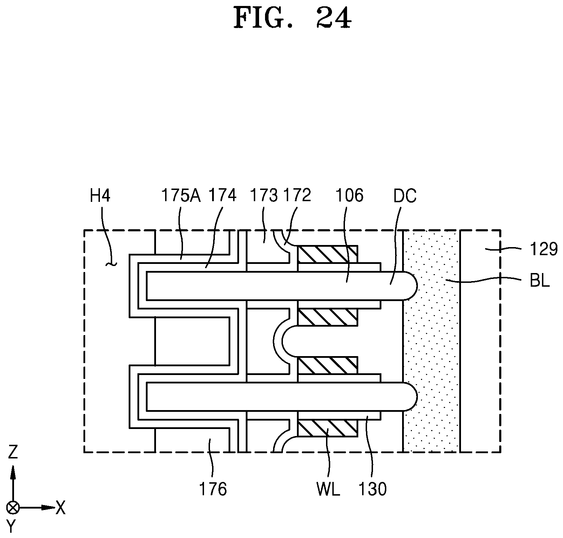

Referring to FIG. 24, a silicon oxide film may be formed to fill the hole H4 in the resultant structure of FIG. 23, and a portion of the silicon oxide film may be removed to form a silicon oxide pattern 176 exposing a portion of the first silicon nitride liner 175A.

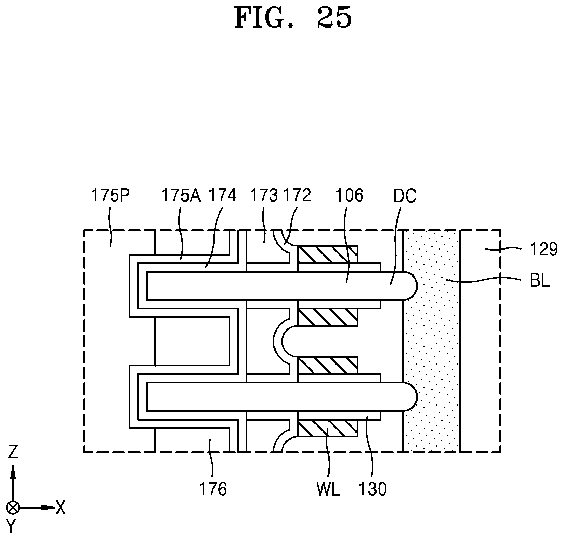

Referring to FIG. 25, in the resultant structure of FIG. 24, a silicon nitride plug 175P may be formed to fill the hole H4.

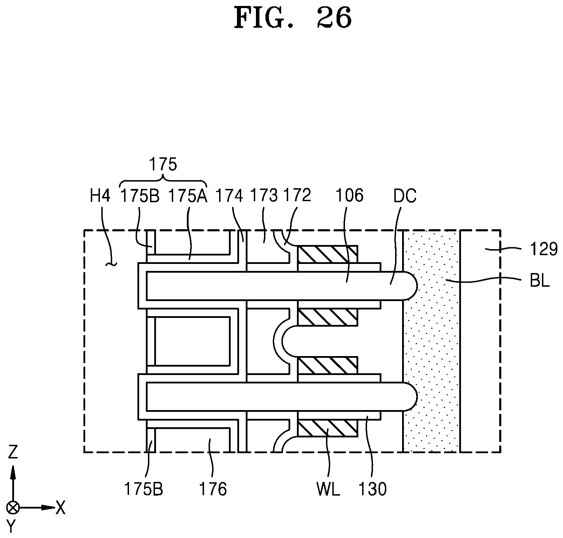

Referring to FIG. 26, a portion of the silicon nitride plug 175P may be removed from the resultant structure of FIG. 25. Thus, a second silicon nitride liner 175B, which includes the remaining portion of the silicon nitride plug 175P, may be formed and partial regions of the first silicon nitride liner 175A may be exposed through the second silicon nitride liner 175B inside the hole H4. The exposed first silicon nitride liner 175A may be removed. The remaining first silicon nitride liner 175A and the second silicon nitride liner 175B may constitute a silicon nitride liner structure 175 that surrounds the silicon oxide pattern 176.

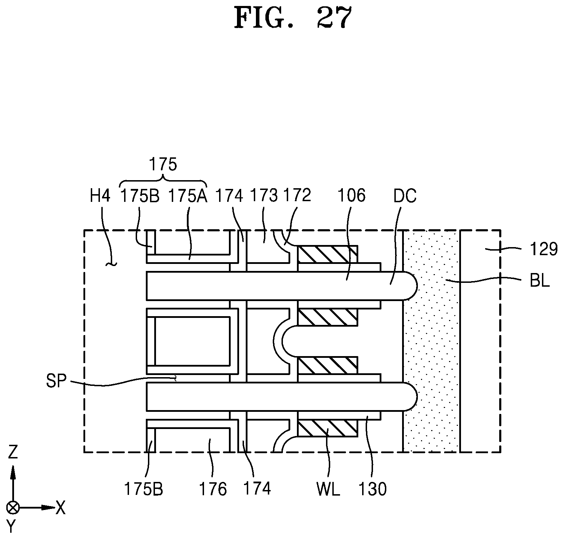

Referring to FIG. 27, in the resultant structure of FIG. 26, a portion of the insulating film 174 may be removed through the hole H4, and thus, spaces SP may be formed around the plurality of active layers 106. The portion of the insulating film 174 may be removed by using a wet etching process or an isotropic dry etching process. During the removal of the insulating film 174, a removed amount of the insulating film 174 may be controlled such that a portion of the insulating film 174 remains between the active layer 106 and the first silicon nitride liner 175A.

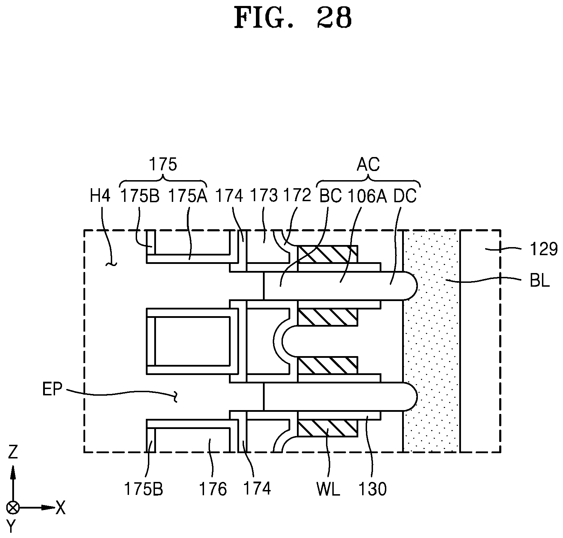

Referring to FIG. 28, a portion of each of the plurality of active layers 106 exposed through the hole H4 may be removed from the resultant structure on which the processes described with reference to FIG. 27 have been performed. Thus, a plurality of electrode spaces EP, of which a width in the vertical direction (Z direction) is defined by the first silicon nitride liner 175A, the insulating film 174, and the insulating liner 172, may be formed adjacent to the plurality of active layers 106. A buried contact BC may be formed in each of the plurality of active layers 106 by doping a dopant into the plurality of active layers 106 through the hole H4 and the plurality of electrode spaces EP, and thus, the plurality of active regions AC may be formed. In embodiments, the dopant may include p-type or n-type impurity ions. For example, the dopant may include boron (B), phosphorus (P), or arsenic (As), without being limited thereto.

A width of each of the plurality of electrode spaces EP in the vertical direction (Z direction), which is defined by the insulating film 174 and the insulating liner 172, may be less than a width of each of the plurality of electrode spaces EP in the vertical direction (Z direction), which is defined by the first silicon nitride liner 175A.

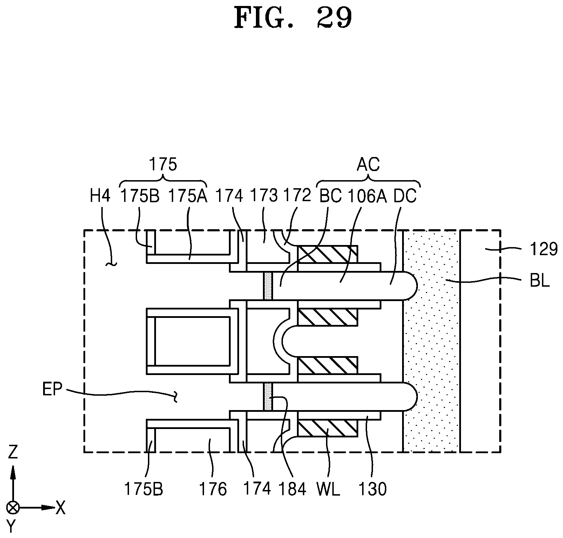

Referring to FIG. 29, a metal silicide film 184 may be formed on a surface of each of the plurality of active regions AC exposed in the plurality of electrode spaces EP. In embodiments, the formation of the metal silicide film 184 may include forming a metal-silicon composite layer by vapor-depositing a metal and silicon on the surface of each of the plurality of active regions AC and silicidating the metal-silicon composite layer by using a thermal annealing process or an annealing process.

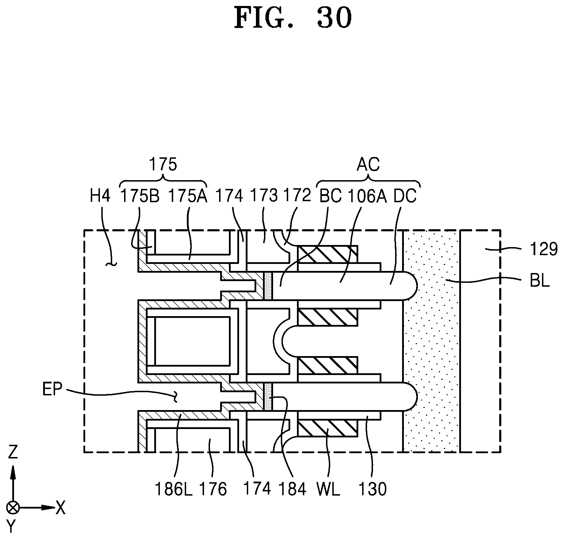

Referring to FIG. 30, a conductive layer 186L may be formed to conformally cover surfaces exposed by the hole H4 and the plurality of electrode spaces EP. A constituent material of the conductive layer 186L may be the same as a constituent material of the first electrode 186, which has been described above.

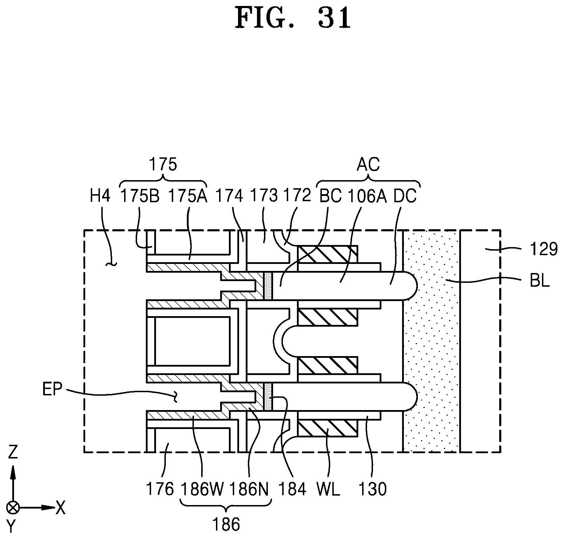

Referring to FIG. 31, portions of the conductive layer 186L, which are outside the plurality of electrode spaces EP, may be removed to form a plurality of first electrodes 186. Each of the plurality of first electrodes 186 may include an electrode support portion 186N and a main electrode portion 186W. The electrode support portion 186N may be adjacent to the buried contact BC of the active region AC. The main electrode portion 186W may be integrally connected to the electrode support portion 186N and be spaced apart from the buried contact BC in the first lateral direction (X direction) with the electrode support portion 186N therebetween.

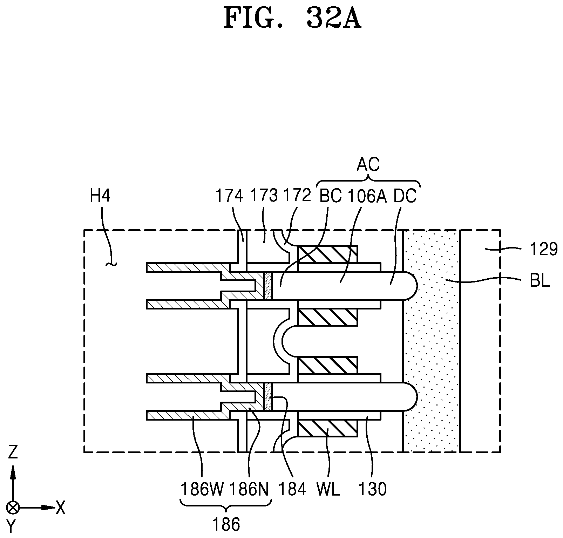

Referring to FIGS. 32A and 32B, the silicon nitride liner structure 175 and the silicon oxide pattern 176 may be removed from the resultant structure on which the processes described with reference to FIG. 31 have been performed. Thus, an outer surface of the main electrode portion 186W of each of the plurality of first electrodes 186 may be exposed.

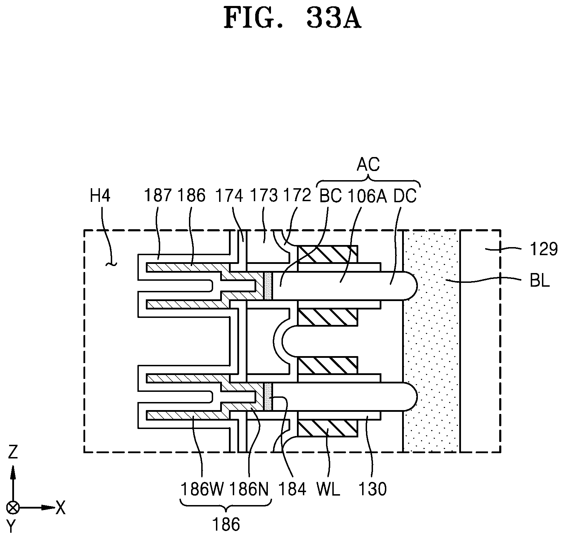

Referring to FIGS. 33A and 33B, in the resultant structure of FIGS. 32A and 32B, a dielectric film 187 may be formed to conformally cover an exposed surface of the main electrode portion 186W of each of the plurality of first electrodes 186 and an exposed surface of the insulating film 174.

Thereafter, as shown in FIGS. 2 to 4, a second electrode 188 covering the dielectric film 187 and a plate electrode 190 may be sequentially formed, and thus, the semiconductor memory device 100 shown in FIGS. 2 to 6 may be manufactured.

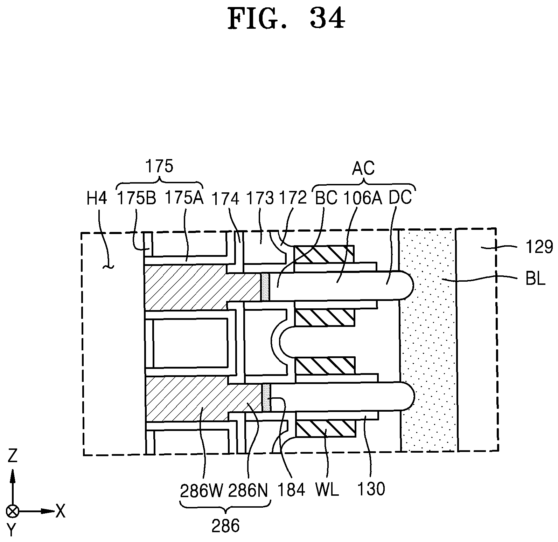

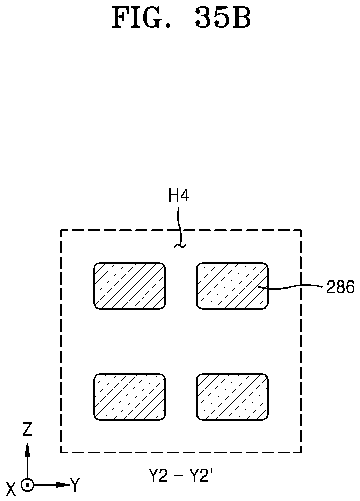

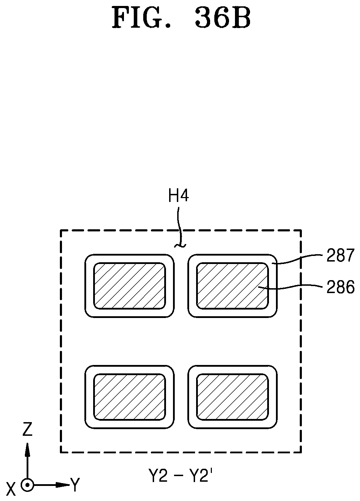

FIGS. 34 to 36B are diagrams of a method of manufacturing a semiconductor memory device, according to embodiments. More specifically, FIGS. 34, 35A, and 36A are each an enlarged cross-sectional view of a region corresponding to the partial region "EX2" of FIG. 7, according to a process sequence. FIGS. 35B and 36B are each a cross-sectional view of a partial region corresponding to a cross-section taken along line Y2 - Y2' of FIG. 2, according to the process sequence. An example of a method of manufacturing the semiconductor memory device 200, which has been described with reference to FIGS. 7 to 9, is described with reference to FIGS. 34 to 36B. In FIGS. 34 to 36B, the same reference numerals are used to denote the same elements as in FIGS. 2 to 9, and thus, repeated descriptions thereof are omitted.

Referring to FIG. 34, the processes described with reference to FIGS. 11 to 29 may be performed. Thereafter, in the resultant structure of FIG. 29, a first electrode 286 may be formed to fill each of a plurality of electrode spaces EP. The first electrode 286 may include an electrode support portion 286N and a main electrode portion 286W. The electrode support portion 286N may be adjacent to a buried contact BC of the active region AC. The main electrode portion 286W may be integrally connected to the electrode support portion 286N and be spaced apart from the buried contact BC in a first lateral direction (X direction) with the electrode support portion 286N therebetween.

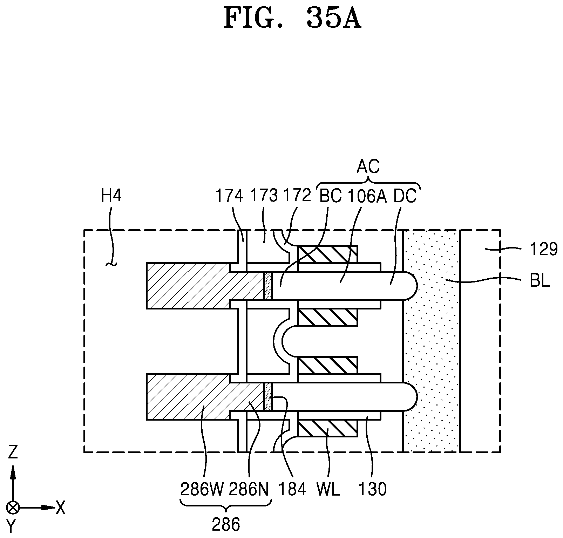

Referring to FIGS. 35A and 35B, a silicon nitride liner structure 175 and a silicon oxide pattern 176 may be removed from the resultant structure on which the processes described with reference to FIG. 34 have been performed. Thus, an outer surface of each of a plurality of first electrodes 286 may be exposed.

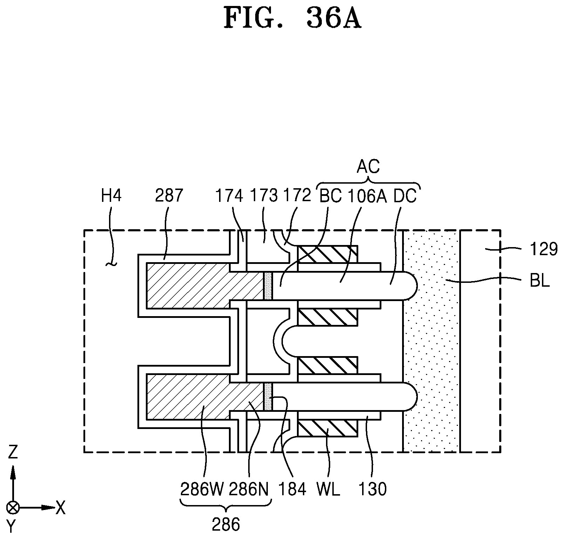

Referring to FIGS. 36A and 36B, in the resultant structure of FIGS. 35A and 35B, a dielectric film 287 may be formed to conformally cover an exposed surface of each of the plurality of first electrodes 286 and an exposed surface of an insulating film 174.

Afterwards, as shown in FIGS. 7 and 8, a second electrode 288 covering the dielectric film 287 and a plate electrode 190 may be sequentially formed, and thus, the semiconductor memory device 200 shown in FIGS. 7 to 9 may be manufactured.

To manufacture the semiconductor memory device 300 shown in FIG. 10, processes similar to those described with reference to FIGS. 11 to 33B may be performed. However, a plurality of first electrodes 386 may be formed instead of the plurality of first electrodes 186 in the processes described with reference to FIGS. 30 and 31. Each of the plurality of first electrodes 386 may be formed to include an electrode support portion 386N and a main electrode portion 386W. The electrode support portion 386N may be adjacent to the buried contact BC of the active region AC. The main electrode portion 386W may be integrally connected to the electrode support portion 386N and be spaced apart from the buried contact BC in the first lateral direction (X direction) with the electrode support portion 386N therebetween. To form the plurality of first electrodes 386, during the formation of the conductive layer 186L described with reference to FIG. 30, a portion of the electrode space EP, which is defined by the insulating film 174 and the insulating liner 172, may be completely filled by the conductive layer 186L to obtain the electrode support portion 386N having a pillar shape, and the conductive layer 186L may conformally cover exposed surfaces in a portion of the electrode space EP, which is defined by the first silicon nitride liner 175A, to obtain the main electrode portion 386W having a cylindrical shape.

Subsequently, the processes described with reference to FIGS. 32A to 36B may be performed on the obtained resultant structure, and thus, the semiconductor memory device 300 shown in FIG. 10 may be manufactured.

Although the methods of manufacturing the semiconductor memory devices 100, 200, and 300 shown in FIGS. 2 to 10 have been described with reference to FIGS. 11 to 36B, it will be understood that the semiconductor memory devices 100, 200, and 300 shown in FIGS. 2 to 10 and semiconductor memory devices having variously changed structures may be manufactured by applying various modifications and changes to the processes described with reference to FIGS. 11 to 36B within the scope of the present disclosure.

While aspects of embodiments have been particularly shown and described, it will be understood that various changes in form and details may be made therein without departing from the scope of the following claims.

## Claims

1. A semiconductor memory device (100) comprising:
an active region (AC) spaced apart from a substrate (102) in a vertical direction (Z) and extending in a first lateral direction (X), the active region (AC) comprising a buried contact (BC), a channel region (106A), and a direct contact (DC), which are sequentially provided in the first lateral direction (X), wherein the first lateral direction (X) is parallel to a main surface (102M) of the substrate (102);
a word line (WL) surrounding the channel region (106A) of the active region (AC) and extending in a second lateral direction (Y), wherein the second lateral direction (Y) is parallel to the main surface (102M) of the substrate (102) and crosses the first lateral direction (X);
a capacitor (CAP) comprising a first electrode (186) comprising an electrode support portion (186N) and a main electrode portion (186W), the electrode support portion (186N) being connected to the buried contact (BC) of the active region (AC) and having a first width (VW1) in the vertical direction (Z), the main electrode portion (186W) being integrally connected to the electrode support portion (186N) and spaced apart from the buried contact (BC) in the first lateral direction (X) with the electrode support portion (186N) therebetween, and the main electrode portion (186W) having a second width (VW2) in the vertical direction (Z) that is greater than the first width (VW1); and
an insulating liner (172) surrounding the buried contact (BC) and the electrode support portion (186N) of the first electrode (186).

2. The semiconductor memory device (100) of claim 1, wherein the capacitor (CAP) further comprises a dielectric film (187) covering a surface of the first electrode (186), and a second electrode (188) that is spaced apart from the first electrode (186) with the dielectric film (187) therebetween,
wherein each of the electrode support portion (186N) and the main electrode portion (186W) of the first electrode (186) has a cylindrical shape defining an inner space accommodating a portion of the dielectric film (187),
wherein an outer surface of the electrode support portion (186N) of the first electrode (186) is spaced apart from the dielectric film (187) with an insulating film (174) therebetween, and
wherein an outer surface of the main electrode portion (186W) of the first electrode (186) is in contact with the dielectric film (187).

3. The semiconductor memory device (100) of claim 1, wherein the capacitor (CAP) further comprises a dielectric film (287) covering a surface of the first electrode (286), and a second electrode (288) that is spaced apart from the first electrode (286) with the dielectric film (287) therebetween,
wherein each of the electrode support portion (286N) and the main electrode portion (286W) of the first electrode (286) has a pillar shape with filled interior,
wherein an outer surface of the electrode support portion (286N) of the first electrode (286) is spaced apart from the dielectric film (287) with an insulating film (174) therebetween, and
wherein an outer surface of the main electrode portion (286W) of the first electrode (286) is in contact with the dielectric film (287).

4. The semiconductor memory device (100) of claim 1, wherein the capacitor (CAP) further comprises a dielectric film (387) covering a surface of the first electrode (386), and a second electrode (388) that is spaced apart from the first electrode (386) with the dielectric film (387) therebetween,
wherein the electrode support portion (386N) of the first electrode (386) has a pillar shape with filled interior,
wherein the main electrode portion (386W) of the first electrode (386) has a cylindrical shape defining an inner space accommodating a portion of the dielectric film (387) and a portion of the second electrode (386),
wherein an outer surface of the electrode support portion (386N) of the first electrode (386) is spaced apart from the dielectric film (387) with an insulating film (174) therebetween, and
wherein an outer surface of the main electrode portion (386W) of the first electrode (386) is in contact with the dielectric film (387).

5. The semiconductor memory device (100) of any preceding claim, wherein the capacitor (CAP) further comprises a dielectric film (187) covering a surface of the first electrode (186), and a second electrode (188) that is spaced apart from the first electrode (186) with the dielectric film (187) therebetween, and
wherein the electrode support portion (186N) of the first electrode (186) protrudes in the first lateral direction (X) toward the buried contact (BC) farther than the dielectric film (187).

6. The semiconductor memory device (100) of any preceding claim, further comprising a metal silicide film (184) between the electrode support portion (186N) of the first electrode (186) and the buried contact (BC), the metal silicide film (184) contacting each of the electrode support portion (186N) and the buried contact (BC),
wherein the metal silicide film (184) is surrounded by the insulating liner (172).

7. The semiconductor memory device (100) of any preceding claim, wherein the electrode support portion (186N) and the main electrode portion (186W) comprises a same material.

8. The semiconductor memory device (100) of any preceding claim, further comprising a bit line (BL) extending lengthwise in the vertical direction (Z) on the substrate (102), the bit line (BL) being connected to the direct contact (DC) of the active region (AC),
wherein the bit line (BL) is spaced apart from the capacitor (CAP) in the first lateral direction (X) with the word line (WL) therebetween.

9. The semiconductor memory device (100) of any preceding claim, further comprising a gate dielectric film (130) between the channel region (106A) of the active region (AC) and the word line (WL), the gate dielectric film (130) surrounding the channel region (106A),
wherein the first width (VW1) of the electrode support portion (186N) is less than a greatest width (VW4) of the gate dielectric film (130) in the vertical direction (Z), the greatest width (VW4) of the gate dielectric film (130) being defined by an outer surface of the gate dielectric film (130).

10. The semiconductor memory device (100) of any preceding claim, wherein the electrode support portion (186N), the buried contact (BC), the channel region (106A), and the direct contact (DC) are aligned and collinear with each other in the first lateral direction (X).

11. A semiconductor memory device (100) comprising:
a memory cell block (CB) having a three-dimensional (3D) structure, the memory cell block (CB) comprising a plurality of memory cells (MC) repeatedly provided on a substrate (102) in a first lateral direction (X), a second lateral direction (Y), and a vertical direction (Z), wherein the first lateral direction (X) and the second lateral direction (Y) cross each other, and the vertical direction (Z) is perpendicular to a main surface (102M) of the substrate (102),
wherein the memory cell block (CB) comprises:
a plurality of active regions (AC) arranged in a line extending in the vertical direction (Z) on the substrate (102);
a plurality of word lines (WL), each of the plurality of word lines (WL) surrounding a selected one of the plurality of active regions (AC) and extending in the second lateral direction (Y), the plurality of word lines (WL) overlapping each other in the vertical direction (Z);
a bit line (BL) extending in the vertical direction (Z) on the substrate (102), the bit line (BL) being connected to one side of each of the plurality of active regions (AC);
a plurality of capacitors (CAP), each of the plurality of capacitors (CAP) comprising a first electrode (186) connected to another side of a selected one of the plurality of active regions (AC), the first electrode (186) comprising an electrode support portion (186N) and a main electrode portion (186W), the electrode support portion (186N) having a first width (VW1) in the vertical direction (Z), the main electrode portion (186W) being integrally connected to the electrode support portion (186N) and spaced apart from the selected active region (AC) in the first lateral direction (X) with the electrode support portion (186N) therebetween, and the main electrode portion (186W) having a second width (VW2) in the vertical direction (Z) that is greater than the first width (VW1); and
a plurality of insulating liners (172), each of the plurality of insulating liners (172) surrounding a selected one of the plurality of active regions (AC) and the electrode support portion (186N) of the first electrode (186) connected to the selected active region (AC).

12. The semiconductor memory device (100) of claim 11, wherein each of the plurality of capacitors (CAP) further comprises a dielectric film (187) covering a surface of the first electrode (186), and a second electrode (188) that is spaced apart from the first electrode (186) with the dielectric film (187) therebetween,
wherein each of the electrode support portion (186N) and the main electrode portion (186W) of the first electrode (186) has a cylindrical shape defining an inner space accommodating a portion of the dielectric film (187),
wherein an outer surface of the electrode support portion (186N) of the first electrode (186) is spaced apart from the dielectric film (187) with an insulating film (174) therebetween, and
wherein an outer surface of the main electrode portion (186W) of the first electrode (186) is in contact with the dielectric film (187).

13. The semiconductor memory device (100) of claim 11, wherein each of the plurality of capacitors (CAP) further comprises a dielectric film (287) covering a surface of the first electrode (286), and a second electrode (288) that is spaced apart from the first electrode (286) with the dielectric film (287) therebetween,
wherein each of the electrode support portion (286N) and the main electrode portion (286W) of the first electrode (286) has a pillar shape,
wherein an outer surface of the electrode support portion (286N) of the first electrode (286) is spaced apart from the dielectric film (287) with an insulating film (174) therebetween, and
wherein an outer surface of the main electrode portion (286W) of the first electrode (286) is in contact with the dielectric film (287).

14. The semiconductor memory device (100) of claim 11, wherein each of the plurality of capacitors (CAP) further comprises a dielectric film (387) covering a surface of the first electrode (386), and a second electrode (388) that is spaced apart from the first electrode (386) with the dielectric film (387) therebetween,
wherein the electrode support portion (386N) of the first electrode (386) has a pillar shape,
wherein the main electrode portion (386W) of the first electrode (386) has a cylindrical shape defining an inner space accommodating a portion of the dielectric film (387) and a portion of the second electrode (388),
wherein an outer surface of the electrode support portion (386N) of the first electrode (386) is spaced apart from the dielectric film (387) with an insulating film (174) therebetween, and
wherein an outer surface of the main electrode portion (386W) of the first electrode (386) is in contact with the dielectric film (387).

15. The semiconductor memory device of any of claims 11-14, further comprising a metal silicide film (184) between the electrode support portion (186N) of the first electrode (186) and a selected one of the plurality of active regions (AC), the metal silicide film (184) contacting each of the electrode support portion (186N) and the selected active region (AC),
wherein the metal silicide film (184) is surrounded by a selected insulating liner (172) of the plurality of insulating liners (172).
